# EUROPEAN PATENT SPECIFICATION

(11) **EP 0 664 487 B1**
(45) Date of publication and mention of the grant of the patent: **29.07.1998**
(21) Application number: 94119353.4
(22) Date of filing: 07.12.1994
(51) Int. Cl.: G03F 7/028, G03F 7/09

(54) **Silver halide light-sensitive material comprising light-sensitive polymerizable layer and an overcoating layer containing polyvinyl alcohol with acidic groups or a salt thereof**
Lichtempfindliches Silberhalogenidmaterial enthaltend eine lichtempfindliche polymerisierbare Schicht und eine Deckschicht, die Polyvinylalkohol mit sauren Gruppen oder einem Salz davon enthält
Matériau photosensible à base de halogénures d'argent comprenant une couche photopolymérisable et une couche de revêtement, qui contient de l'alcool polyvinylique avec des groupes acides ou un sel de ce composé

(30) Priority: 08.12.1993 JP 340627/93
(43) Date of publication of application: 26.07.1995
(73) Proprietor: FUJI PHOTO FILM CO., LTD., Kanagawa (JP)
(72) Inventor: Yokoya, Hiroaki, Fuji Photo Film Co.,Ltd, Haibara-gun, Shizuoka (JP); Endo, Akihiro, Fuji Photo Film Co.,Ltd, Haibara-gun, Shizuoka (JP)
(74) Representative: Grünecker, Kinkeldey, Stockmair & Schwanhäusser Anwaltssozietät

(56) References cited:
- DE-A- 4 203 532
- DE-A- 4 215 035
- GB-A- 819 945
- US-A- 4 731 291
- US-A- 5 122 443
- US-A- 5 227 278

## Description

### FIELD OF THE INVENTION

The present invention relates to a silver halide light-sensitive material, which comprises a support and a light-sensitive polymerizable layer containing silver halide, a reducing agent and an ethylenically unsaturated polymerizable compound or a cross-linkable polymer. The silver halide functions as a photosensor. A polymer image is formed by hardening the polymerizable compound.

### BACKGROUND OF THE INVENTION

U.S. Patent No. 4,629,676 (Hayakawa et al) and European Patent Publication No. 0174634B1 disclose an image forming method comprising the steps of imagewise exposing to light a light-sensitive material, and heating the light-sensitive material. The light-sensitive material comprises a support and a light-sensitive polymerizable layer containing silver halide, a reducing agent and a polymerizable compound. The light-sensitive material is heated to develop the silver halide and to harden the polymerizable compound.

U.S. Patent No. 5,122,443 (Takeda) and European Patent Publication No. 0426192B1 discloses an embodiment of the above-mentioned light-sensitive material, which is advantageously used for the preparation of a lithographic plate. In the disclosed light-sensitive material, a cross-linkable polymer can be used in place of or in addition to the polymerizable compound. Further, the light-sensitive polymerizable layer comprises a polymerizable layer containing the polymerizable compound or the cross-linkable polymer and a light-sensitive layer containing silver halide. An overcoating layer may be provided on the light-sensitive layer. The overcoating layer is also disclosed in U.S. Patent No. 5,290,659 (Takeda). The above-mentioned light-sensitive material can also be advantageously used for the preparation of a color proof, which is disclosed in U.S. Patents No. 5,304,454 (Yokoya et al.), No. 5,326,667 (Yokoya et al.) and No. 5,328,800 (Yokoya et al.).

As is described in U.S. Patent No. 5,122,443 (at column 20, lines 1 to 43) and European Patent Publication No. 0426192B1 (at page 14, lines 4 to 26), a polyvinyl alcohol having a high saponification degree (preferably not less than 70 %, more preferably not less than 80 %, and most preferably not less than 95 %) is preferably used as a hydrophilic binder contained in the light-sensitive layer or the overcoating layer. Such a polyvinyl alcohol has a function of preventing influence of oxygen in the air (which has a function of inhibiting a polymerization reaction). A polymerization reaction at heat development can smoothly proceed by the function of the polyvinyl alcohol of a high saponification degree. This effect is remarkable when the saponification degree is not less than 95 %.

### SUMMARY OF THE INVENTION

The present inventors have studied the polyvinyl alcohol used as a binder of a light-sensitive layer or an overcoating layer.

As is described in U.S. Patent No. 5,122,443 and European Patent Publication No. 0426192B1, a polyvinyl alcohol of a high saponification degree is advantageously used at a heat development process. However, the inventors note a problem of such a polyvinyl alcohol at a stage of washing out after the heat development.

An overcoating layer or a light-sensitive layer is often removed from the light-sensitive material in the preparation of a printing plate or a color proof. The material is washed with water to remove the layer after the heat development. At the washing stage, the removed layer is not dissolved in washing water to cause sludge in waste water. The sludge was remarkably observed in the case that a polyvinyl alcohol of a high saponification degree was used as a binder. According to further study of the present inventors, the polyvinyl alcohol of a high saponification degree is crystallized with heat at heat development. The crystallized polyvinyl alcohol is scarcely dissolved in water, and thus causes the sludge.

An object of the present invention is to provide a silver halide light-sensitive material which can form a clear image even in the case that the material is developed with heat while opening the surface of the material in the air.

Another object of the invention is to provide a silver halide light-sensitive material from which an overcoating layer or a light-sensitive layer containing polyvinyl alcohol can easily be removed with water.

The present invention provides a silver halide light-sensitive material which comprises a support, a light-sensitive polymerizable layer and an overcoating layer in that order, said light-sensitive polymerizable layer containing silver halide, a reducing agent and an ethylenically unsaturated polymerizable compound or a cross-linkable polymer, wherein the overcoating layer contains polyvinyl alcohol having an acidic group or a salt thereof in its molecule, the acidic group being carboxyl, sulfo or phosphono.

The invention also provides a silver halide light-sensitive material which comprises a support, a polymerizable layer and a light-sensitive layer in that order, said polymerizable layer containing an ethylenically unsaturated polymerizable compound or a cross-linkable polymer, said light-sensitive layer containing silver halide, and a reducing agent being contained in the polymerizable layer or the light-sensitive layer, wherein the light-sensitive layer further contains polyvinyl alcohol having an acidic group or a salt thereof in its molecule, the acidic group being carboxyl, sulfo or phosphono.

The present invention is characterized in that polyvinyl alcohol having an acidic group or a salt thereof in its molecule as specified above is used as a binder of a light-sensitive material or an overcoating layer.

According to study of the present inventors, the crystallization of polyvinyl alcohol at an elevated temperature can be prevented by an acidic group. In more detail, the acidic group is introduced into the molecule of the polyvinyl alcohol. Accordingly, the polyvinyl alcohol having the acidic group has a high solubility in water even after heating the polyvinyl alcohol. Further, the introduced acidic group does not inhibit the function of preventing influence of oxygen in the air.

As a result, the silver halide light-sensitive material of the present invention forms a clear image even in the case that the material is developed with heat while opening the surface of the material in the air. Further, an overcoating layer or a light-sensitive layer containing polyvinyl alcohol can easily be removed with water from the silver halide light-sensitive material of the present invention.

The layer containing the polyvinyl alcohol usually further contains a base precursor. Accordingly, the acidic moiety of the polyvinyl alcohol and the base precursor are usually contained in the same layer. According to study of the present inventors, however, the acidic moiety does not disturb the function of the base precursor.

### BRIEF DESCRIPTION OF THE DRAWING

Fig. 1 is a sectional view schematically illustrating an embodiment of a silver halide light-sensitive material of the present invention.

Fig. 2 is a sectional view schematically illustrating another embodiment of a silver halide light-sensitive material of the invention.

### DETAILED DESCRIPTION OF THE INVENTION

First, polyvinyl alcohol having an acidic group or a salt thereof in its molecule is described below.

The acidic group means an anionic group, which can release a proton, and is selected from carboxyl, sulfo or phosphono. Carboxyl is particularly preferred.

The acidic group can form a salt with a cation. A metal cation is preferably used to form the salt. An alkali metal ion (e.g., sodium ion) is particularly preferred. A modified polyvinyl alcohol in the form of a salt usually has a stable molecular structure, compared with the form of a free acid.

In the preparation of the polyvinyl alcohol used in the present invention, the above-mentioned acidic group or a salt thereof is introduced into the molecule of the polyvinyl alcohol. Accordingly, the polyvinyl alcohol used in the invention is classified into modified polyvinyl alcohol (modified poval). Modified povals are described in "Poval" (revised edition), pages 280 to 285 (Kobunshi Kanko-kai, written in Japanese).

Normal polyvinyl alcohol is usually prepared by saponifying polyvinyl acetate. An acidic group can be introduced into polyvinyl alcohol by (1) copolymerization modification at the stage of synthesis of polyvinyl acetate or (2) post-modification after the preparation of the normal polyvinyl alcohol.

In the copolymerization modification (1), vinyl acetate is copolymerized with an organic acid (or a derivative thereof) having an ethylenically unsaturated group. Examples of the ethylenically unsaturated organic acids include acrylic acid, methacrylic acid and styrenesulfonic acid. The derivatives of the organic acids include a salt, an ester, an amide and an anhydride. For example, an ethylenically unsaturated organic amide (e.g., acrylamide, methacrylamide, N,N-dimethylacrylamide) is available in the invention.

The copolymer of vinyl acetate and an ethylenically unsaturated organic acid is saponified in the same manner as in the saponification of normal polyvinyl alcohol to prepare polyvinyl alcohol having an acidic group. In the case that the organic acid is in the form of an ester, an amide or an anhydride, hydrolysis proceeds at the saponification to from an acidic group from the ester, amide or anhydride.

According to the post-modification (2), hydroxyl of polyvinyl alcohol reacts with an acid having two or more acidic groups (dibasic acid, tribasic acid, tetrabasic acid). Thus one of acidic groups of the acid binds forms an ester bond with hydroxyl. The other acidic groups remain as free state.

An acid having two or more carboxyl groups (dicarboxylic acid, tricarboxylic acid, tetracarboxylic acid) is preferably used. An acid having carboxyl groups can be used in the form of an anhydride. For example, maleic anhydride, phthalic anhydride, trimellitic anhydride, succinic anhydride, adipic anhydride and itaconic anhydride are available.

The modified polyvinyl alcohol used in the present invention can effectively be synthesized according to the above-mentioned process (1) or (2). The process of post-modification (2) is rather easy to produce the modified polyvinyl alcohol or to obtain a commercial product.

The modified polyvinyl alcohol preferably has a molecular weight in the range of 3,000 to 500,000. In the modified polyvinyl alcohol, a vinyl acetate unit may remain in the molecule. In other words, the saponification degree should not be 100 %. Further, it is rather difficult to produce polyvinyl alcohol having 100 % saponification degree. The saponification degree is preferably not less than 70 %, and more preferably not less than 90 %.

As is described above, the polyvinyl alcohol used in the present invention is a copolymer having (A) a vinyl acetate unit, (B) a vinyl alcohol unit and (C) a modified acidic unit. The units may be arranged as a graft copolymer or a random copolymer. The random copolymer is preferred.

Preferred copolymer prepared by a copolymerization modification (1) is represented by the following formula.

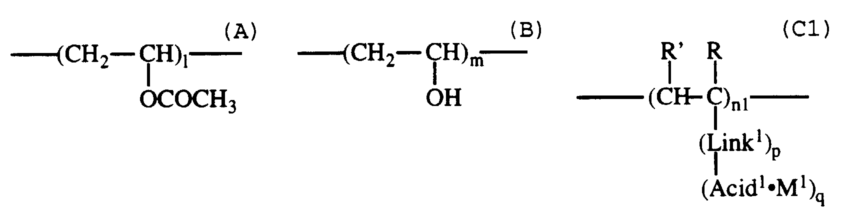

In the formula, (A) means a vinyl acetate unit, (B) means a vinyl alcohol unit, and (C1) means a modified unit, which is introduced by a copolymerization modification (1).

The ratio of l to l+m+n1 is 0 to 0.3, and more preferably is 0 to 0.1. The vinyl acetate unit (A) may be deleted from the copolymer (namely l may be 0).

The ratio of m to l+m+n1 is 0.5 to 0.999.

The ratio of nl to l+m+n1 is 0.001 to 0.2, and more preferably is 0.005 to 0.1.

In the unit (C1), R is hydrogen, an alkyl group, carboxyl or a salt thereof. The alkyl group preferably is a lower alkyl group having 1 to 6 carbon atoms. The alkyl group most preferably is methyl. R' is hydrogen, carboxyl or a salt thereof.

In the unit (C1), p is 0 or 1. Link¹ is a linking group having valences of q+1. Link¹ may be deleted from the unit (namely p may be 0).

In the unit (C1), q is a natural number, and usually is 1 or 2. Acid¹ is an acidic moiety (carboxyl, sulfo or phosphono). M¹ is a cation, and preferably is a proton or an alkali metal ion.

Examples of modified polyvinyl alcohol prepared by a copolymerization modification (1) are shown in Table 1 referring to the above-mentioned units (A), (B) and (C1).

**TABLE 1**

| No. | l | m | n1 | R' | R | Link¹ | p | Acid¹ | M¹ | q |
|---|---|---|---|---|---|---|---|---|---|---|
| (1) | 17 | 600 | 13 | COOH | H | None | 0 | COO⁻ | H⁺ | 1 |
| (2) | 20 | 700 | 20 | H | COOH | CH₂ | 1 | COO⁻ | H⁺ | 1 |
| (3) | 15 | 550 | 11 | COONa | H | None | 0 | COO⁻ | Na⁺ | 1 |
| (4) | 22 | 450 | 25 | H | CH₃ | None | 0 | COO⁻ | H⁺ | 1 |

Preferred copolymer prepared by a post-modification (2) is represented by the following formula.

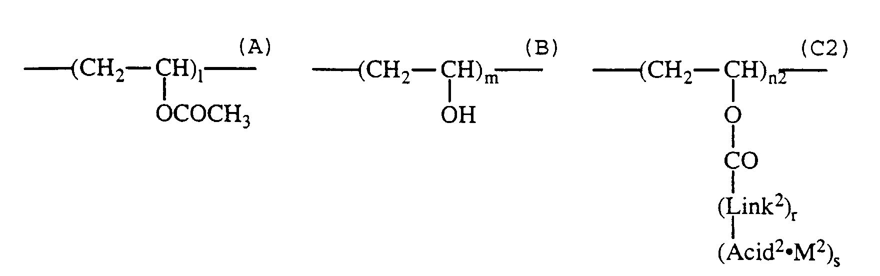

In the formula, (A) means a vinyl acetate unit, (B) means a vinyl alcohol unit, and (C2) means a modified unit, which is introduced by a post modification (2).

The ratio of 1 to l+m+n2 is 0 to 0.3, and more preferably is 0 to 0.1. The vinyl acetate unit (A) may be deleted from the copolymer (namely 1 may be 0).

The ratio of m to l+m+n2 is 0.5 to 0.999.

The ratio of n2 to l+m+n2 is 0.001 to 0.2, and more preferably is 0.005 to 0.1.

In the unit (C2), r is 0 or 1. Link² is a linking group having valences of s+1. Link² may be deleted from the unit (namely r may be 0).

In the unit (C2), s is a natural number, and usually is 1 or 2. Acid² is an acidic moiety (carboxyl, sulfo or phosphono). M² is a cation, and preferably is proton or an alkali metal ion.

Examples of modified polyvinyl alcohol prepared by a post-modification (2) are shown in Table 2 referring to the above-mentioned units (A), (B) and (C2).

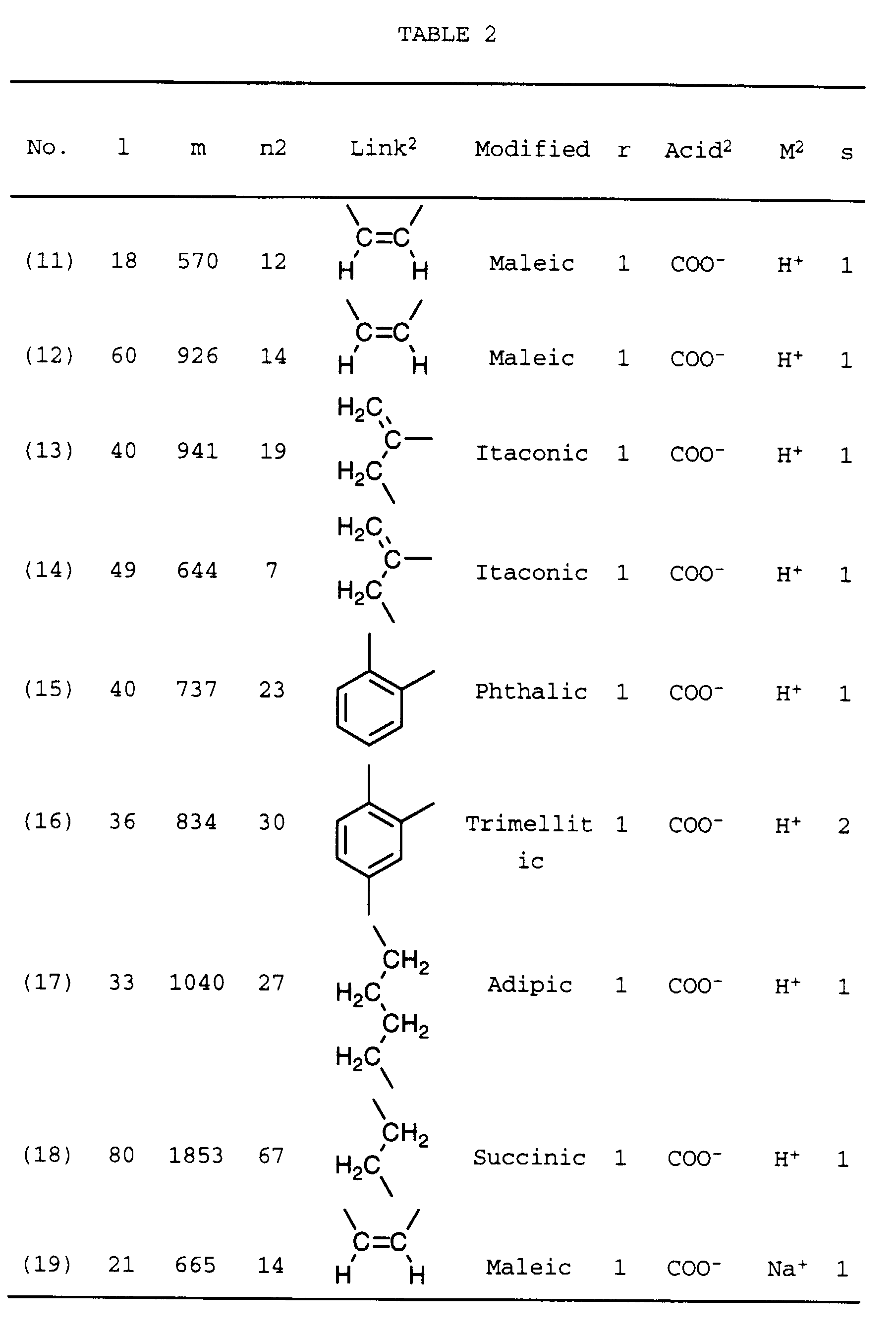

The above-mentioned modified polyvinyl alcohol is commercially available. Examples of commercial products include Kuraray Poval KM-118, KL-118, KL-318, KL-506, KM-618 (Kuraray Co., Ltd.) and Gosenal T, Goseran L-3266 (Nippon Synthetic Chemical Industry Co., Ltd.).

Two or more modified polyvinyl alcohols may be used in combination.

An overcoating layer or a light-sensitive layer contains the polyvinyl alcohol in an amount of 0.05 to 20 g/m², and more preferably of 0.1 to 10 g/m².

The acid modified polyvinyl alcohol used in the present invention can be used in combination with another polyvinyl alcohol.

The layer containing the polyvinyl alcohol (the overcoating layer or the light-sensitive layer) preferably does not contain sodium acetate substantially. The upper limit of sodium acetate is less than 1 wt.%.

According to study of the present inventors, sodium acetate contained in the overcoating layer or the light-sensitive layer inhibits development of silver halide. Accordingly, the density of silver image is decreased by sodium acetate. Therefore, the hardening reaction of a polymerizable layer is also inhibited, and the hardness of the hardened film is decreased. As a result, the resolving power and the plate wear are degraded. This phenomenon is remarkable in the case that the overcoating layer or the light-sensitive layer contains sodium acetate in an amount of not less than 1 wt.%.

Sodium acetate is contained in polyvinyl alcohol as impurity substance. Accordingly, the overcoating layer or the light-sensitive layer is contaminated with sodium acetate, which is contained in polyvinyl alcohol used in the layer. Polyvinyl alcohol is usually prepared by saponifying vinyl acetate. The saponification reaction usually proceeds in a methanol solution of sodium hydroxide at an elevated temperature. In the solution, acetic ester of polyvinyl acetate is hydrolyzed to form polyvinyl alcohol. At this reaction, acetic acid is formed as a by-product. The acetic acid turns sodium acetate under a basic condition of sodium hydroxide. The formed sodium acetate remains as impurity in polyvinyl alcohol.

The amount of sodium acetate remaining in polyvinyl alcohol depends on the conditions of the saponification reaction and other producing reactions. The amount of sodium acetate in polyvinyl alcohol directly relates to the amount contained in the light-sensitive material.

Therefore, sodium acetate is preferably removed from polyvinyl alcohol before the preparation of the light-sensitive material. For example, polyvinyl alcohol can be purified according to the following manner.

Polyvinyl alcohol is added to methanol containing 1 to 2 % of water. The amount of methanol is about twice as much as the amount of polyvinyl alcohol. The mixture is stirred at 40 to 50 °C for 1 to 2 hours. Polyvinyl alcohol is filtered off. These procedures are repeated some times to reduce the amount of sodium acetate.

It is not clear how sodium acetate inhibits the development of silver halide and the hardening reaction. It is assumed that sodium acetate inhibits the increase of pH in the light-sensitive layer containing developing silver halide, which results the inhibition of the silver halide development.

In the case that sodium acetate in an amount of 1 wt.% or more is experimentally added to the overcoating layer or the light-sensitive layer, the development of silver halide and the hardening reaction are also inhibited.

In the light-sensitive material having no overcoating layer, the amount of sodium acetate contained in the light-sensitive layer is preferably less than 1 wt.%, more preferably less than 0.7 wt.% and most preferably less than 0.5 wt.% based on the total amount of the light-sensitive layer. In the light-sensitive material having an overcoating layer, the amount of sodium acetate is preferably less than 1 wt.%, more preferably less than 0.7 wt.% and most preferably less than 0.5 wt.% based on the total amount of the light-sensitive layer and the overcoating layer.

Synthesis examples and purification examples of polyvinyl alcohol are shown below. The acid modified polyvinyl alcohol used in the present invention can also be purified in a similar manner.

### SYNTHESIS EXAMPLE 1

In 500 g of methanol, 200 g of polyvinyl acetate (polymerization degree: 700) was dissolved. While stirring the solution at 35 °C, 30 g of sodium hydroxide in 300 g of methanol was added to the solution. As a result, 7 °C rise in temperature of the solution was observed. After a few minutes, precipitation was also observed. The obtained precipitate was filtered off, and was crashed in a grinder. The precipitate was washed with 5 l of methanol, and dried at 90 °C for 4 hours to obtain polyvinyl alcohol. The saponification degree was 98 %, and the sodium acetate content was 5 wt.%.

### PURIFICATION EXAMPLE 1

Polyvinyl alcohol obtained in the synthesis example 1 was purified in the following manner.

To 200 g of methanol containing 1 % water, 100 of polyvinyl alcohol obtained in the synthesis example 1 was added. The mixture was stirred at 50 °C for 2 hours. Polyvinyl alcohol was then filtered off. The procedures were repeated seven times to obtain purified polyvinyl alcohol containing 0.3 wt.% sodium acetate (saponification degree: 98 %).

### SYNTHESIS EXAMPLE 2

The procedures in the synthesis example 1 were repeated except that 20 g of sodium hydroxide was used. Thus, partially saponified polyvinyl alcohol (saponification degree: 85 %) was obtained. The sodium acetate content in polyvinyl alcohol was 7 wt.%.

### PURIFICATION EXAMPLE 2

The procedures in the purification example 2 were repeated except that polyvinyl alcohol obtained in the synthesis example 2 was used. Thus, partially saponified polyvinyl alcohol (saponification degree: 85 %) was obtained. The sodium acetate content in the purified polyvinyl alcohol was 0.35 wt.%.

Using the above-mentioned polyvinyl alcohol having a low sodium acetate content, the sodium acetate content in the overcoating layer and/or the light-sensitive layer can be adjusted to less than 1 %. A light-sensitive material having such layers is improved in the progress of silver halide development and the density of silver image. Further, the hardness of the polymerizable layer is improved by such layers to obtain a hard relief image. As a result, the resolving power, the expression of fine dots (highlight area) and the plate wear are improved.

### [Layered structure of light-sensitive material]

The layered structure of the light-sensitive material can be determined according to use of the material. In the case that the light-sensitive material is used for the preparation of a lithographic plate or a color proof, the light-sensitive polymerizable layer preferably comprises a light-sensitive layer containing silver halide and a polymerizable layer containing the ethylenically unsaturated polymerizable compound or the cross-linkable polymer. The reducing agent can be contained in the light-sensitive layer or the polymerizable layer. Further, the other optional layers can be provided in the silver halide light-sensitive material. An overcoating layer can be provided on the light-sensitive polymerizable layer.

In the case that the overcoating layer is provided, the above-mentioned acid modified polyvinyl alcohol used in the present invention is used as a binder of the overcoating layer.

In the case that the overcoating layer is not provided, the acid modified polyvinyl alcohol is used as a binder of the light-sensitive layer.

The other optional layers may be provided in the light-sensitive material. The optional layers include an undercoating layer, an adhesive layer, a strippable layer, an intermediate layer and a backing layer.

The layered structure is further described referring to the drawings.

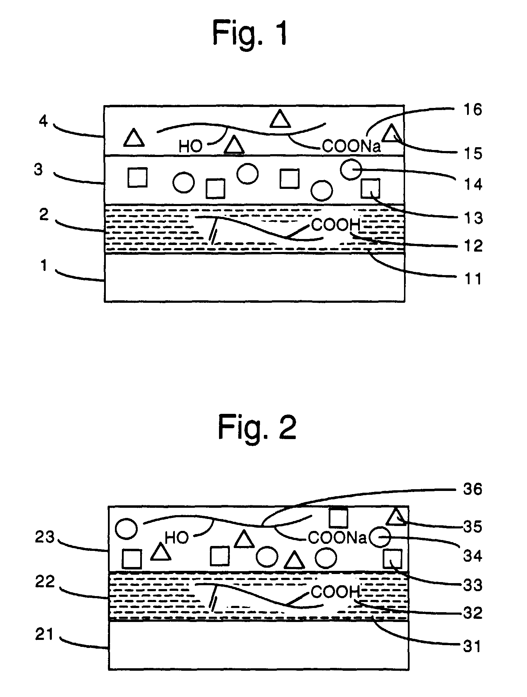

Fig. 1 is a sectional view schematically illustrating an embodiment of a silver halide light-sensitive material of the present invention.

As is shown in Fig. 1, the silver halide light-sensitive material comprises a support (1), a polymerizable layer (2), a light-sensitive layer (3) and an overcoating layer (4) in that order. The polymerizable layer (2) contain an ethylenically unsaturated polymerizable compound (11) and a cross-linkable polymer (12). The light-sensitive layer (3) contains silver halide (13) and a reducing agent (14). The overcoating layer (4) contains a base precursor (15) and a specific polyvinyl alcohol (16).

Fig. 2 is a sectional view schematically illustrating another embodiment of a silver halide light-sensitive material of the invention.

As is shown in Fig. 2, the silver halide light-sensitive material comprises a support (21), a polymerizable layer (22) and a light-sensitive layer (23). The polymerizable layer (22) contain an ethylenically unsaturated polymerizable compound (31) and a cross-linkable polymer (32). The light-sensitive layer (23) contains silver halide (33), a reducing agent (34), a base precursor (35) and a specific polyvinyl alcohol (36).

### [Light-sensitive layer]

The light-sensitive layer contains silver halide, which forms a radical after an exposing step and a developing step. The formed radical is transferred to a polymerizable layer to cause a hardening reaction.

The light-sensitive layer preferably has a thickness in the range of 0.1 to 20 µm, and more preferably in the range of 0.5 to 10 µm.

### [Polymerizable layer]

The polymerizable layer contains an ethylenically unsaturated polymerizable compound or a cross-linkable polymer. The polymerizable layer is hardened by a polymerization reaction or a cross-linking reaction.

The polymerizable layer preferably has a thickness in the range of 0.1 to 20 µm, and more preferably in the range of 0.3 to 7 µm.

### [Overcoating layer and image formation accelerating layer]

An overcoating layer has a function of preventing oxygen in the air from permeating into the polymerizable layer. Oxygen functions as a polymerization inhibitor. Accordingly, the hardness of the polymerizable layer can be improved by providing the overcoating layer. The overcoating layer can also function as a protective layer. The image formation accelerating layer contains a component (e.g., a base or base precursor, a reducing agent, a heat development accelerator) which accelerates an image forming reaction. The image formation accelerating layer has another function of the above-mentioned overcoating layer.

These layers may contain a matting agent, which has a function of reducing adhesion on the surface of the silver halide light-sensitive material to prevent adhesion when the materials are stacked.

The overcoating layer or the image formation accelerating layer preferably has a thickness in the range of 0.3 to 20 µm, and more preferably in the range of 0.5 to 10 µm.

The overcoating layer or the image formation accelerating layer is usually made of a hydrophilic polymer. A hydrophobic polymer is also available. The hydrophobic layer can be formed by dissolving a hydrophobic polymer in a solvent and coating the solution. Further, the layers can be formed by coating a polymer latex. The layer containing a hydrophobic polymer should be removed after a heat development and before an etching treatment.

### [Adhesive layer]

An adhesive layer can be provided in the silver halide light-sensitive material to form a toner image. The adhesive layer contains a polymer, to which toner particles adhere.

The adhesive polymer preferably is a natural or synthetic rubber. Examples of the synthetic rubbers include polyisobutylene, nitryl rubber, butyl rubber, chlorinated rubber, polyvinyl isobutyl rubber, silicon elastomer, neoprene and a copolymer rubber (e.g., styrene-butadiene copolymer, styrene-isobutylene copolymer). The copolymer may be any of a random copolymer, a block copolymer and a graft copolymer.

The adhesive layer preferably has a thickness in the range of 0.01 to 10 µm, and more preferably in the range of 0.05 to 5 µm.

### [Strippable layer]

A strippable layer can be provided in the silver halide light-sensitive material to form a transferred image.

The strippable layer is not adhesive at room temperature so that it is easily removed from the support. The layer is usually adhesive at an elevated temperature. The strippable layer usually contains an organic polymer (e.g., polyvinyl acetal resin, polyamide resin) as matrix. The matrix polymer preferably has a flow softening point that is higher than a heating temperature required for developing silver halide.

The strippable layer preferably contains a fluorine compound in an amount of not less than 1 wt.%. A fluorine surface active agent is preferably used as the fluorine compound.

The strippable layer preferably has a thickness of not less than 1.0 µm, and more preferably of not less than 1.4 µm.

### [Intermediate layer]

An intermediate layer can be provided in the silver halide light-sensitive material.

The intermediate layer can function as an antihalation layer or a barrier layer. The barrier layer prevents components from moving between layers when the light-sensitive material is stored. The composition of the intermediate layer is determined according to its function. The intermediate layer can be made of a hydrophilic polymer used in the light-sensitive layer or the overcoating layer.

The intermediate layer preferably has a thickness of not more than 10 µm.

### [Support]

The support can be made of a paper, a synthetic paper, a paper laminated with a synthetic resin (e.g., polyethylene, polypropylene, polystyrene), a plastic film (e.g., polyethylene terephthalate, polycarbonate, polyimide, Nylon, cellulose triacetate), a metal plate (e.g., aluminum, aluminum alloy, zinc, iron, copper) or a paper or plastic film laminated with the metal. Further, the metal can be evaporated onto the paper or plastic film to form the support.

In the case that the light-sensitive material is used for the preparation of a lithographic plate, the support is preferably made of aluminum plate, polyethylene terephthalate film, polycarbonate film, a paper or a synthetic paper. A complex sheet can also be available. For example, aluminum sheet can be laminated on the polyethylene terephthalate film.

Aluminum support is particularly preferred. The aluminum support preferably has a thickness in the range of 0.1 to 0.5 mm.

The aluminum support is preferably treated to form a rough surface (graining treatment) or a hydrophilic surface.

The treatment for the rough surface can be conducted by an electrochemical graining treatment and/or a mechanical graining treatment. According to the electrochemical graining treatment, a current passes through an aluminum plate in an electrolytic solution of hydrochloric acid or nitric acid. The mechanical graining treatment includes a wire brushing method, a ball graining method and a brash graining method. In the wire brushing method, the surface of aluminum plate is scratched with a metal wire. In the ball graining method, the surface of aluminum plate is grained with graining balls and a graining agent. In the brash graining method, the surface is grained with a Nylon brash and a graining agent.

The grained aluminum plate is then chemically etched with an alkali or an acid. An alkali etching method is industrially advantageous. Examples of the alkali agents include sodium carbonate, sodium aluminate, sodium metasilicate, sodium phosphate, sodium hydroxide, potassium hydroxide and lithium hydroxide. The alkali solution preferably has a concentration in the range of 1 to 50 wt.%. The temperature of the alkali treatment is preferably in the range of 20 to 100 °C. The treatment conditions are preferably so adjusted that the amount of the dissolved aluminum is in the range of 5 to 20 g/m².

The aluminum plate is usually washed with an acid to remove smut from the surface after the alkali etching treatment. Examples of the acids include nitric acid, sulfuric acid, phosphoric acid, chromic acid, hydrofluoric acid and borofluoric acid.

The smut removing treatment can also be conducted after the electrochemical graining treatment according to a conventional method. For example, an aluminum plate can be treated with 15 to 65 wt.% sulfuric acid at a temperature in the range of 50 to 90 °C.

The surface treated aluminum plate can be subjected to an anodizing treatment or a chemical treatment. The anodizing treatment can be conducted according to a conventional method. In more detail, a direct or alternative current passes through an aluminum plate in a solution of an acid to form an anodic oxide layer on the surface of the plate. Examples of the acids include sulfuric acid, phosphoric acid, chromic acid, oxalic acid, sulfamic acid and benzenesulfonic acid. The conditions of the anodizing treatment depend on the contents of the electrolytic solution. The concentration of the electrolytic solution is preferably in the range of 1 to 80 wt.%, the temperature of the solution is preferably in the range of 5 to 70 °C, the current density is preferably in the range of 0.5 to 60 A/dm2, the voltage is preferably in the range of 1 to 100 v, and the time for the electrolysis is preferably in the range of 10 to 100 seconds.

The anodizing treatment is preferably conducted in sulfuric acid at a high current density. Phosphoric acid is also preferably used for the anodizing treatment.

After the anodizing treatment, the aluminum plate can be treated with an alkali metal silicate. For example, the aluminum plate can be immersed in an aqueous solution of sodium silicate. An undercoating layer can be provided on the aluminum support to improve the adhesion between the support and the polymerizable layer or to improve a printing character.

### [Undercoating layer]

Examples of the components of the undercoating layer include a polymer (e.g., casein, polyvinyl alcohol, ethyl cellulose, phenol resin, styrene-maleic anhydride resin, polyacrylic acid), an amine (e.g., monoethanol amine, diethanol amine, triethanol amine, tripropanol amine) and a salt thereof (e.g., chloride, oxalate, phosphate), an monoaminomonocarboxylic acid (aminoacetic acid, alanine), an oxyamino acid (serine, threonine, dihydroxyethylglycine), a sulfur containing amino acid (e.g., cysteine, cystine), a monoaminodicarboxylic acid (e.g., aspartic acid, glutamic acid), an amino acid having an aromatic ring (e.g., p-hydroxylphenylglycine, phenylalanine, anthranilic acid), an aliphatic aminosulfonic acid (e.g., sulfamic acid, cyclohexylsulfamic acid) and a (poly)aminopolyacetic acid (e.g., ethylenediaminetetraacetic acid, nitrilotriacetic acid, iminodiacetic acid, hydroxyethyliminodiacetic acid, hydroxyethylethylenediamineacetic acid, ethylenediaminediacetic acid, cycloethylenediaminetetraacetic acid, diethylenetriaminepentaaceitic acid, glycoletherdiaminetetraacetic acid). All or a part of the acidic groups of the above-mentioned compound may form a salt (e.g., sodium salt, potassium salt, ammonium salt). Two or more components can be used in combination.

### [Silver halide]

Silver halide is silver chloride, silver bromide, silver iodide, silver chlorobromide, silver chloroiodide, silver iodobromide or silver chloroiodobromide in the form of grains.

The crystal forms of silver halide grains preferably are cubic or tetradecahedron. In addition to these regular crystals, irregular forms and mixed forms are available. Examples of the irregular forms include a potato-like form, a spherical form and a tabular form. The tabular form usually has an aspect ratio (diameter per thickness) of 5 or more.

The silver halide grains may be extremely small grains having a grain diameter (diameter of projected area) of less than 0.01 µm. The grains may also be relatively large grains having a diameter of more 10 µm. The silver halide emulsion may be a polydispersed emulsion or a monodispersed emulsion. The monodispersed emulsion is described in U.S. Patents No. 3,574,628 and No. 3,655,394 and British Patent No. 1,413,748.

With respect to the crystal structure of the silver halide grains, the individual grains may have a homogeneous halogen composition or a heterogeneous halogen composition. In the heterogeneous composition, the composition varies from the outer surface portion to the inside portion. The grains may have a multi-layered structure. Further, the silver halide grains may be bonded with other silver halide grains having different halogen composition through epitaxial bonding. The grains may be bonded with compounds other than the silver halide such as silver rhodanate and lead oxide.

Various substances in the form of salt can be added to the silver halide according to a conventional process at the grain formation or after the grain formation. Examples of the substances include copper, thallium, lead, cadmium, zinc, a chalcogen such as sulfur, selenium and tellurium, gold, and a group III noble metal such as rhodium, iridium, iron, platinum and palladium. The conventional process is described in U.S. Patents No. 1,195,432, No. 1,191,933, No. 2,448,060, No. 2,628,167, No. 2,950,972, No. 3,488,709, No. 3,737,313, No. 3,772,031, No. 4,269,927 and Research Disclosure (RD), No. 13,452 (June 1975).

The silver halide grains can be doped with iridium ion by adding an aqueous solution of an iridium compound to a silver halide emulsion. Examples of water-soluble iridium compounds include hexachloroiridic(III) salts and hexachloroiridic(IV) salts. The silver halide grains can also be doped with rhodium ion by adding an aqueous solution of a rhodium compound to a silver halide emulsion. Examples of water-soluble rhodium compounds include rhodium ammonium chloride, rhodium trichloride and rhodium chloride.

The iridium compound or the rhodium compound can be dissolved in a halide solution for forming silver halide grains. The aqueous solution of the iridium compound or the rhodium compound can be used before or after the grain formation. Further, the solution can be added to the emulsion between the grain formation and a chemical sensitization. The solution is preferably added at the stage of the grain formation. The iridium or rhodium ion is preferably used in an amount of 10⁻⁸ to 10⁻³ mol, and more preferably in an amount of 10⁻⁷ to 10⁻⁵ mol based on 1 mol of silver halide. In the case that iridium compound and the rhodium compound are used in combination, the rhodium compound is preferably added to the emulsion before the addition of the iridium compound.

Two or more kinds of silver halide grains that differ in halogen composition, crystal habit, grain size, or other features from each other can be used in combination.

The silver halide is preferably used in the form of an emulsion. The silver halide emulsion can be prepared by known processes, which are described in Research Disclosure (RD), No. 17,643, pages 22 to 23 (December 1978), (Emulsion preparation and types); and Research Disclosure, No. 18,716, p. 648, (November 1979).

The silver halide emulsion is generally used after a physical ripening and a chemical sensitization.

Various additives can be used in the ripening or sensitizing steps. The additives are described in Research Disclosure, No. 17,643 and No. 18,716. The chemical sensitizer is described in No. 17,643 (page 23) and No. 18,716 (page 648, right column). Other additives are also described in Research Disclosure. For example, a sensitivity-increasing agent is described in No. 18,716 (page 648, right column). An anti-fogging agent and a stabilizer are described in No. 17,643 (pages 24 to 25) and No. 18,716 (page 649, right column), respectively.

Silver halide grains preferably have a relatively low fogging value.

The silver halide emulsion is usually subjected to a spectral sensitization. Various spectral sensitizing dyes are known in a conventional silver halide photography. Examples of the sensitizing dyes include cyanine dyes, merocyanine dyes, complex merocyanine dyes, holopolar cyanine dyes, hemicyanine dyes, styryl dyes and hemioxonol dyes.

A supersensitizer can be added to the emulsion in addition to the sensitizing dye. The supersensitizer itself has neither a spectral sensitization effect nor an absorption of visible light, but shows a supersensitizing effect on the sensitizing dye.

### [Organic metallic salt]

An organic metallic salt can be added to the light-sensitive layer containing silver halide. An organic silver salt is particularly preferred.

Examples of organic moieties of the salts include triazoles, tetrazoles, imidazoles, indazoles, thiazoles, thiadiazoles, azaindenes. An aliphatic, aromatic or heterocyclic compound having a mercapto group is also available as the organic moiety. Further, silver carboxylates and acetylene silver are available as the organic silver salt. Two or more organic metallic salts can be used in combination.

The organic silver salt is generally used in an amount of 10⁻⁵ to 10 mol, and preferably 10⁻⁴ to 1 mol based on 1 mol of silver halide. A similar effect can be obtained by adding the organic moiety of the organic metallic salt in place of the salt itself to the light-sensitive layer containing silver halide. The organic moiety can partially react with the silver halide to form the organic metallic salt.

### [Reducing agent]

The reducing agent has a function of reducing the silver halide or a function of accelerating (or inhibiting) a hardening reaction of the polymerizable compound or the cross-linkable polymer. There are known various reducing agents having the functions. Examples of the reducing agents include hydroquinones, catechols, p-aminophenols, p-phenylenediamines, 3-pyrazolidones, 3-aminopyrazoles, 4-amino-5-pyrazolones, 5-aminouracils, 4,5-dihydroxy-6-aminopyrimidines, reductones, aminoreductones, o- or p-sulfonamidophenols, o- or p-sulfonamidonaphthols, 2,4-disulfonamidephenols, 2,4-disulfonamidenaphthols, o- or p-acylaminophenols, 2-sulfonamidoindanones, 4-sulfonamido-5-pyrazolones, 3-sulfonamidoindoles, sulfonamidopyrazolobenzimidazoles, sulfonamidopyrazolotriazoles, α-sulfonamidoketones and hydrazines.

The reducing agents (including compounds referred to as developing agent or hydrazine derivative) are described in Japanese Patent Provisional Publications 61(1986)-183640, No. 61(1986)-183535, No. 61(1986)-228441, No. 62(1987)-70836, No. 61(1987)-86354, No. 62(1987)-86355, No. 62(1987)-206540, No. 62(1987)-264041, No. 62(1987)-109437 and No. 63(1988)-254442, and Japanese Patent Applications No. 63(1988)-97379, No. 63(1988)-296774, No. 63(1988)-296775, No. 1(1989)-27175, No. 1(1989)-54101 and No. 1(1989)-91162. The reducing agents are also described in T. James, The Theory of the Photographic Process, 4th edition, pages 291 to 334 (1977), Research Disclosure, Vol. 170, No. 17029, pages 9 to 15 (June 1978), and Research Disclosure, Vol. 176, No. 17643, pages 22 to 31 (December 1978). Further, a reducing agent precursor is also available. The precursor can release a reducing agent under heating or in contact with a base.

When the reducing agent is basic, that is, it forms a salt with an acid, the reducing agent can be used in the form of a salt with an acid. The reducing agents can be used singly or in combination. Certain interactions between those reducing agents may be expected where two or more reducing agents are used in combination. One of the interactions is for an acceleration of reduction of silver halide (or an organic silver salt) through so-called super-additivity. The other interaction is for a chain reaction between an oxidant of one reducing agent formed by a reduction of silver halide (or an organic silver salt) oxidation-reduction reaction and another reducing agent. The chain reaction induces or inhibits the polymerization of the polymerizable compound. Both interactions may occur simultaneously. Thus, it is difficult to determine which of the interactions has occurred in practical use.

The reducing agent is used in an amount of 0.1 to 10 mol, and more preferably 0.25 to 2.5 mol based on 1 mol of silver halide.

By adjusting the kind or amount of the above reducing agent, the polymerizable compound or the cross-linkable polymer can be hardened within the area where a latent image of the silver halide has been formed.

The reducing agent itself can be oxidized to form an oxidation product when the reducing agent develops silver halide. In the case that the oxidation product is decomposed in the layer to form a radical, a polymerization reaction proceeds within the area where the latent image of silver halide has been formed. In this system, hydrazines are preferably used as the reducing agent.

On the other hand, the reducing agent itself or the oxidation product may have a function of inhibiting the polymerization. In this case, the oxidation product substantially does not form a radical. A polymerization is caused by a polymerization initiator within the area where the latent image of silver halide has not been formed (in the case that the inhibiting function of the oxidation product is stronger than that of the reducing agent) or has been formed (in the case that the inhibiting function of the reducing agent is stronger than that of the oxidation product). In these systems, l-phenyl-3-pyrazolidones and hydroquinones are preferably used as the reducing agent. Further, the following polymerization initiator should be contained in the light-sensitive material of these systems.

### [Polymerization initiator]

A thermal polymerization initiator is described in Addition Polymerization and Ring Opening Polymerization, pages 6 to 18, edited by the Editorial Committee of High Polymer Experimental Study of the High Polymer Institute, published by Kyoritsu Shuppan (1983). Examples of the thermal polymerization initiators include: azo compounds such as azobisisobutyronitrile, 1,1-azobis(1-cyclohexanecarbonitrile), dimethyl-2,2'-azobisisobutyrate, 2,2-azobis(2-methylbutyronitrile) and azobisdimethylbaleronitrile; organic peroxides such as benzoyl peroxide, di-t-butyl peroxide, dicumyl peroxide, t-butyl hydroperoxide and cumene hydroperoxide; inorganic peroxides such as hydrogen peroxide, potassium persulfate and ammonium persulfate; and sodium p-toluenesulfinic acid.

The photopolymerization initiator is described in Oster et al., Chemical Review, vol. 68, pages 125 to 151 (1968) and Kosar, Light-Sensitive System, pages 158 to 193, John Wiley & Sons (1965). Examples of the photopolymerization initiator include carbonyl compounds (e.g., α-alkoxyphenyl ketones, polycyclic quinones, benzophenone derivatives, xanthones, thioxanthones and benzoines), halogen-containing compounds (e.g., chlorosulfonyl or chloromethyl polynuclear aromatic compounds, chlorosulfonyl or chloromethyl heterocyclic compounds, chlorosulfonyl or chloromethyl benzophenones and fluorenones), haloalkanes, a-halo-a-phenylacetophenones, redox couples of photo-reducible dye and reducing agent, organic sulfur compounds, peroxides, photo semi-conductors (e.g., titanium dioxide and zinc oxide), metallic compounds (e.g., ferrous salt, metallic salt of carbonyl compound, metal complex and uranyl salt), silver halide, azo compounds and diazo compounds.

Concrete examples of the photopolymerization initiators include 2-dimethoxy-2-phenylacetophenone, 2-methyl-[4-(methylthio)phenyl]-2-morpholino-1-propanone, benzoin butyl ether, benzoinisopropyl ether, benzophenone, Michler's ketone, 4,4-diethylaminobenzophenone, chloromethylbenzophenone, chlorosulfonylbenzophenone, 9,10-anthraquinone, 2-methyl-9,10-anthraquinone, chlorosulfonyl anthraquinone, chloromethyl anthraquinone, 9,10-phenanthrenequinone, xanthone, chloroxanthone, thioxanthone, chlorothioxanthone, 2,4-diethylthioxanthone, chlorosulfonylthioxanthone, chloromethylbenzothiazole, chlorosulfonylbenzoxazole, chloromethylquinoline, fluorene and carbon tetrabromide.

The polymerization initiator is used in an amount of preferably 0.001 to 0.5 g, and more preferably 0.01 to 0.2 g based on 1 g of the polymerizable compound.

### [Polymerizable compound]

The polymerizable compound used in the present invention has an ethylenically unsaturated group.

Examples of the ethylenically unsaturated polymerizable compounds include acrylic acids, salts of acrylic acids, acrylic esters, acrylamides, methacrylic acids, salts of methacrylic acids, methacrylic esters, methacrylamides, maleic anhydride, maleic esters, itaconic esters, styrenes, vinyl ethers, vinyl esters, N-vinyl heterocyclic compounds, allyl ethers, allyl esters, and derivatives thereof. Acrylic esters and methacrylic esters are preferred.

Examples of the acrylic esters include n-butyl acrylate, cyclohexyl acrylate, 2-ethylhexyl acrylate, benzyl acrylate, furfuryl acrylate, ethoxyethoxyethyl acrylate, tricyclodecanyloxy acrylate, nonylphenyloxyethyl acrylate, 1,3-dioxolane acrylate, hexanediol diacrylate, butanediol diacrylate, neopentyl glycol diacrylate, trimethylolpropane triacrylate, tricyclodecanedimethylol diacrylate, pentaerythritol tetraacrylate, dipentaerythritol pentaacrylate, dipentaerythritol hexacrylate, diacrylate of polyoxyethylenated bisphenol A, 2-(2-hydroxy-1,1-dimethylethyl)-5-hydroxymethyl-5-ethyl-1,3-dioxanediacrylate, 2-(2-hydroxy-1,1-dimethylethyl)-5,5-dihydroxymethyl-1,3-dioxanetriacrylate, triacrylate of propylene oxide addition product of trimethylolpropane, polyacrylate of hydroxypolyether, polyester acrylate and polyurethane acrylate.

Examples of the methacrylic esters include methyl methacrylate, butyl methacrylate, ethylene glycol dimethacrylate, butanediol dimethacrylate, neopentyl glycol dimethacrylate, trimethylolpropane trimethacrylate, pentaerythritol trimethacrylate, pentaerythritol tetramethacrylate and dimethacrylate of polyoxyalkylenated bisphenol A.

### [Cross-linkable polymer]

The cross-linkable polymer used in the present invention has a functional group that is reactive to a radical. The polymer may be a homopolymer or a copolymer with a monomer that does not have a reactive group.

The cross-linkable polymers include:
(A) a polymer having a double bond in a main chain or a side chain of its molecule, to which a radical (a polymerization initiator radial or a growing radical at polymerization reaction of a polymerizable compound) can be added; and
(B) a polymer that forms a polymer radical by removing an atom (hydrogen, a halogen atom such as chlorine) from a main chain or a side chain.

The polymer (A) is described in Japanese Patent Provisional Publication No. 64(1990)-17047. Examples of the polymers include: a polymer having an ethylenically unsaturated double bond in its side chain (e.g., a homopolymer or a copolymer of allyl (meth)acrylate, 1,2-polybutadiene, 1,2-polyisoprene); a polymer having an unsaturated double bond in its main chain (e.g., poly-1,4-butadiene, poly-1,4-isoprene and copolymers thereof); and a natural or synthetic rubber.

The polymer (B) is described at pages 147 to 192 in Polymer Reaction (edited by Polymer Society in Japan, Kyoritsu Shuppan, 1978). Examples of the polymers include poly(meth)acrylate, polyvinyl butyral, polyvinyl formal, polyvinyl pyrrolidone, polyvinyl acetate, polyvinylidene chloride, chlorinated polyethylene, chlorinated polypropylene, polycarbonate, diacetyl cellulose, cellulose acetate butyrate, triacetyl cellulose, ethyl cellulose, polyvinyl pyridine, polyvinyl imidazole and copolymers thereof. Examples of the copolymers include vinyl acetate-ethylene copolymer and vinylidene chloride-acrylonitrile copolymer.

In the case that an alkaline solution is used to remove the unhardened area, the cross-linkable polymer preferably contains an acidic functional group in its molecule. Examples of the acidic functional groups include carboxyl, an acid anhydride group, phenolic hydroxyl, sulfo, sulfonamido and sulfonimido. Examples of the acidic monomers include acrylic acid, methacrylic acid, styrenesulfonic acid and maleic anhydride. The amount of the monomer having the acidic functional group is preferably in the range of 1 to 50 mol %, and more preferably in the range of 5 to 30 mol %.

The polymerizable monomer and the cross-linkable polymer can be used singly or in combination of two or more monomers or polymers.

The polymerizable monomer and the cross-linkable polymer is preferably contained in the polymerizable layer in an amount of 3 to 90 wt.% based on the total amount of the polymerizable layer. The amount is more preferably in the range of 15 to 60 wt.%.

### [Binder of polymerizable layer]

A binder may be added to the polymerizable layer of the multi-layered light-sensitive material to enhance the strength of the layer. Various natural or synthetic polymers are available as the binder. The above-mentioned cross-linkable polymer can also function as the binder.

The synthetic polymer can be formed by an addition reaction or a condensed reaction. The synthetic polymers of the addition reaction type include various vinyl polymers including homopolymers and copolymers. Examples of the condensed polymers include polyesters, polyamides, polyurethanes and polyester-polyamides.

In the case that an alkaline solution is used to remove the unhardened area, the binder polymer preferably contains an acidic functional group in its molecule. Examples of the acidic functional groups include carboxyl, an acid anhydride group, phenolic hydroxyl, sulfo, sulfonamido and sulfonimido. Examples of the acidic monomers include acrylic acid, methacrylic acid, styrenesulfonic acid and maleic anhydride. The amount of the monomer having the acidic functional group is preferably in the range of 1 to 50 mol %, and more preferably in the range of 5 to 30 mol %.

The binder polymer preferably is a cross-linkable acidic polymer. An example of the cross-linkable acidic polymer is a copolymer of allyl (meth)acrylate with (meth)acrylic acid.

An image can be obtained only using a cross-linkable polymer, such as a polymer having an ethylenically unsaturated side chain. However, an ethylenically unsaturated polymerizable compound is used to form a hard polymer image. Further, an image can also be obtained only using the ethylenically unsaturated polymerizable compound. However, the polymerizable compound is usually in the form of liquid. Accordingly, a binder polymer is preferably added to a polymerizable layer to obtain an appropriate hardness of the layer.

The amount of the binder is usually not more than 80 wt.%, and preferably not more than 70 wt.% based on the total amount of the polymerizable layer.

### [Base and base precursor]

The light-sensitive material preferably contains a base or base precursor.

Various organic or inorganic bases and their precursors (e.g., decarboxylation type, thermal decomposition type, reaction type and complex salt-formation type) are available.

Inorganic bases are described in Japanese Patent Provisional Publication No. 62(1987)-209448. Examples of the organic bases include tertiary amine compounds (described in Japanese Patent Provisional Publication No. 62(1987)-170954), bisamidine compounds, trisamidine compounds or tetraamidine compounds (described in Japanese Patent Provisional Publication No. 63(1988)-316760) and bisguanidine compounds, trisguanidine compounds or tetraguanidine compounds (described in Japanese Patent Provisional Publication No. 64(1989)-68746). In the present invention, a base having a pKa value of not less 7 is preferred.

In the present invention, a base precursor is preferred to the base from the viewpoint of the storage stability of the light-sensitive material.

Preferred examples of the base precursors include salts of organic acids with bases that is decarboxylated under heating and urea compounds which release bases under heating. Examples of the reaction mechanisms of the base precursor include a reaction between the base precursor and a salt containing anion having higher compatibility with transition metal acetylide or transition metal ion than acetylide anion, and a reaction of introducing into water both of a basic metallic compound which is hardly dissolved in water and a compound capable of reacting with metal ion of the basic metallic compound in a water medium to form a complex salt so as to release a base through a reaction between those two compounds in the presence of water.

The base precursor preferably releases a base at a temperature in the range of 50 to 200 °C, and more preferably in the range of 80 to 160 °C.

The base or the base precursor can be used in an amount of preferably 0.1 to 20 mol, and more preferably 0.2 to 10 mol based on 1 mol of silver halide.

### [Heat development accelerator]

The light-sensitive material can contain a heat development accelerator. The heat development accelerator may be contained in any layers of the light-sensitive material. The heat development accelerator has a function of increasing the plasticity of a polymer (contained in the polymerizable layer or the light-sensitive layer). The accelerator has another function of accelerating the dispersion of the components in the layers when it is dissolved by heat of the development process.

The heat development accelerator has been known as a plasticizer. The known plasticizers are described in Plastic Additives (written in Japanese), pages 21 to 63 (Taisei-sha); Plastics Additives, Second Edition; Hanser Publishers, Chapter 5, pages 251 to 296; Thermoplastic Additives, Marcel Dekker Inc., Chapter 9, pages 345 to 379; Plastic Additives, An Industrial Guide, Noyes Publications, Section 14, pages 333 to 485: The Technology of Solvents and Plasticizers, John Wiley & Sons, Inc., Chapter 15, pages 903 to 1027; Industrial Plasticizers, Pergamon Press; Plasticizer Technology, Vol. 1, Reinhold Publishing corp.; and Plasticization and Plasticizer Process, American Chemistry.

Examples of the heat development accelerator include glycols (e.g., diethylene glycol, dipropylene glycol), polyhydric alcohols (e.g., glycerol, butanediol, hexanediol), saccharides, formates, ureas (e.g., urea, diethylurea, ethyleneurea, propyleneurea), a urea resin, a phenol resin, amides (e.g., acetamide, propionamide) and sulfonamides. Two or more heat development accelerators can be used in combination. The heat development accelerators can be added to two or more layers of the light-sensitive material. The amount of the heat development accelerator is preferably in the range of 0.05 to 2 g/m², and more preferably in the range of 0.1 to 1 g/m².

### [Colorant]

The light-sensitive material may contain a colorant. The colorant can function as an antihalation or antiirradiation dye. Further, a hardened image can be colored by the colorant. Various known dyes and pigments are available as the colorant provided that the colorant does not affect the sensitivity and the developing reaction of silver halide. The colorant can be contained in the polymerizable layer in the case that the colorant is used to function as an antihalation dye or to color a hardened image. The colorant can also be contained in the light-sensitive layer in the case that the colorant is used to function as an antiirradiation dye. The hue of the antihalation or antiirradiation dye is preferably adjusted within the sensitive light region of silver halide.

The pigments are commercially available. Further, pigments are described in various publications such as Handbook of Color Index, New Handbook of Pigments, (Nippon Ganryo Gijutsu Kyokai (edition), 1977), New Applied Technique of Pigments, (CMC Publishing, 1986), and Technique of Printing Ink, (CMC Publishing, 1984).

Examples of the pigments include black pigments, yellow pigments, orange pigments, brown pigments, red pigments, violet pigments, blue pigments, green pigments, fluorescent pigments, metal powder pigments and polymer pigments. Concrete examples of the pigments include insoluble azo pigments, azo lake pigments, condensation azo pigments, chelate azo pigments, phthalocyanine pigments, anthraquinone pigments, perylene pigments, perynone pigments, thioindigo pigments, quinacridone pigments, dioxadine pigments, isoindolinone pigments, quinophthalone pigments, dye-type lake pigments, azine pigments, nitroso pigments, nitro pigments, natural pigments, fluorescent pigments and inorganic pigments.

The pigment can be itself used or can be used after being subjected to surface treatment. The surface treatments include a method of coating a resin or wax on the surface, a method of depositing a surface active agent thereon and a method of bonding a reactive substance to the surface. Examples of the reactive substances include silane coupling agent, epoxy compound and polyisocyanate. Those methods are described, for example, in Nature and Application of Metal Soap, (Saiwai Shobo), Technique of Printing Ink, (CMC Publishing, 1984), and New Applied Technique of Pigments, (CMC Publishing, 1986).

The particle size of the pigment is preferably in the range of 0.01 to 10 µm, and more preferably in the range of 0.05 to 1 µm. For dispersing the pigment in a coating solution of the polymerizable layer, various conventional dispersing techniques for ink or toner are available. Examples of dispersing devices include a sand mill, an attritor, a pearl mill, a super mill, a ball mill, an impeller, a disperser, a KD mill, a colloid mill, a dyatron, a three-roll mill and a press kneader. The details are described in New Applied Technique of Pigments, (CMC Publishing, 1986).

The dyes are described in "Handbook of Dyes," Yuki Kagaku Kyokai (edition), 1970. Examples of the dyes include azo dyes, metal complex salt azo dyes, pyrazolone azo dyes, anthraquinone dyes, quinonimine dyes and methine dyes.

The antiirradiation dyes are described in Japanese Patent Publications No. 41(1966)-20389, No. 43(1968)-3504, No. 43(1968)-13168, Japanese Provisional Publications No. 2(1990)-39042, U.S. Patents No. 2,865,752, No. 3,423,207, No. 3,697,037, and British Patents No. 1,030,392, No. 1,100,546.

The amount of the colorant is usually in the range of 0.01 to 2 g/m², and preferably in the range of 0.05 to 1 g/m².

### [The other additives]

The light-sensitive material can contain the other additives such as an antifogging agent, a silver development accelerator and a stabilizer.

Examples of these compounds include azoles, azaindenes, nitrogen-containing carboxylic acids, phosphoric acids and acetylene compounds. The azoles and the azaindenes are described in Research Disclosure pages 24 to 25 (1978). The nitrogen-containing carboxylic acids and the phosphoric acids are described in Japanese Patent Provisional Publication No. 59(1984)-168442. The acetylene compounds are described in Japanese Patent Provisional Publication No. 62(1987)-87957. These compounds are generally used in an amount of 10⁻⁷ to 1 mol based on 1 mol of the silver halide.

### [Development stopping agent]

The development stopping agent can be used in the light-sensitive material to obtain a clear image constantly regardless of the temperature and time for the development process. The development stopping agent can be a compound having a function of neutralizing a base or reacting with a base to reduce the base concentration in the layer to stop development. The agent can also be a compound having a function of mutually reacting with silver or a silver salt to suppress development, after the appropriate development. Examples of the development stopping agents include acid precursors capable of releasing acids upon heating, electrophilic compounds capable of undergoing substitution reaction with a coexisting base upon heating, nitrogen-containing heterocyclic compounds, mercapto compounds, and precursors thereof. The development stopping agent is described in Japanese Patent Provisional Publications No. 62(1987)-253159, No. 2(1990)-42447 and No. 2(1990)-262661.

### [Surface active agent]

A surface active agent may be contained in a layer of the light-sensitive material. Various nonionic, anionic, cationic or fluorine surface active agents are available. The surface active agent is described in Japanese Patent Provisional Publication No. 2(1990)-195356. Sorbitan, polyoxyethylene and a fluorine-containing compound are preferred.

### [Matting agent]

A matting agent can be added to a back layer, an overcoating layer or an image formation accelerating layer. The matting agent is well known in the conventional silver halide photography. Inorganic or organic solid particles are available as the matting agent. The matting agent is usually dispersed in a hydrophilic colloidal binder.

Examples of the inorganic matting agents include oxides (e.g., silicon dioxide, titanium dioxide, magnesium oxide, aluminum oxide), alkali earth metal salts (e.g., barium sulfate, strontium sulfate, magnesium sulfate, potassium carbonate), silver halide particles (which does not form an image) and glass.

Examples of the organic matting agents include starch, cellulose esters, cellulose ethers and synthetic resins. The synthetic resins are preferably not or slightly soluble in water. The synthetic resins can be made from alkyl acrylate, alkyl methacrylate, alkoxyalkyl acrylate, alkoxyalkyl methacrylate, glycidyl acrylate, glycidyl methacrylate, acrylamide, methacrylamide, vinyl ester, acrylonitrile, olefin, styrene and benzoguanamine. The synthetic resin polymer may be in the form of a copolymer. The copolymer can be made from the above-mentioned monomers and the other monomers, such as acrylic acid, methacrylic acid, α,β-unsaturated dicarboxylic acid, hydroxyalkyl acrylate, sulfoalkyl acrylate, sulfoalkyl methacrylate and styrenesulfonic acid.

An epoxy resin, nylon, polycarbonate, a phenol resin, polyvinyl carbazole and polyvinylidene chloride are available as the matting agent.

The matting agent may be soluble in an alkaline solution. An example of the alkaline-soluble matting agent is alkyl methacrylate-methacrylic acid copolymer. The alkaline-soluble matting agent is described in Japanese Patent Provisional Publications No. 53(1978)-7231, No. 58(1983)-66937, No. 60(1985)-8894. The alkaline-soluble matting agent may have an anionic group, as is described in Japanese Patent Provisional Publication No. 58(1983)-166341.

The average particle size of the matting agent is preferably in the range of 1 to 50 µm. The particle size distribution may be monodispersed or polydispersed. The maximum particle size of the matting agent is preferably not more than 30 µm. The particles of not more than 20 µm is preferably 10 volume % of the total amount of the matting agent.

The amount of the matting agent is preferably in the range of 0.01 to 1 g/m², and more preferably in the range of 0.1 to 0.7 g/m².

### [Polymerization inhibitor]

A polymerization inhibitor may be added to the polymerizable layer to prevent the dark reaction. Various known polymerization inhibitors are available. Examples of the polymerization inhibitors include a nitrosoamine, a thiourea, a thioamide, a urea compound, a phenol derivative, a nitrobenzene derivative and an amine. Concrete examples include aluminum salt of cupferron, N-nitrosodiphenylamine, allylthiourea, an aryl phosphate, p-toluidine, φ-toluquinone, nitrobenzene, pyridine, phenothiazine, β-naphthol, naphthylamine, t-butylcatechol, phenothiazine, chloranil, p-methoxyphenol, pyrogallol, hydroquinone and an alkyl or aryl-substituted hydroquinone.

### [Exposing step]

The wavelength of the light corresponds to the spectral sensitivity of silver halide. Examples of the light sources include a tungsten lamp, a halogen lamp, a xenon lamp, a xenon flash lamp, a mercury lamp, a carbon arc lamp, various laser means (e.g., semiconductor laser, helium neon laser, argon ion laser, helium cadmium laser), light emitting diode and cathode-ray tube. The wavelength is usually with in the visible, near ultraviolet and near infrared regions. A X-ray and an electron bean are also available. The amount of the exposure is determined by a sensitivity of the silver halide emulsion. The amount is usually in the range of 0.01 to 10,000 ergs/cm².

### [Developing step]

The light-sensitive material is developed simultaneously with or after the exposing step. The light-sensitive material is preferably heated to develop the silver halide. However, a wet development using a developing solution is also available.

The heat development can be conducted by placing the light-sensitive material on a heated material (e.g., metal plate, block, roller). The light-sensitive material may be immersed in a heated liquid for the development. Further, the light-sensitive material may be irradiated with an infrared ray. The surface of the light-sensitive material may be open to the air while heating the material from the side of the support. The surface of the light-sensitive material may be covered with the heating means to prevent the air from penetrating into the layers. In the case that the surface is open to the air, a layer of the light-sensitive material preferably contains a polymer having a function of prevent the air from penetrating into the layers.

The heating temperature is preferably in the range of 60 to 200 °C, and more preferably in the range of 100 to 150 °C. The heating time is preferably in the range of 1 to 180 seconds, and more preferably in the range of 5 to 60 seconds.

A preheat treatment or post-heat treatment can be conducted before or after the heat development. The temperature of the preheat is lower than the heat development temperature, and the time is shorter than the development time. The post-heat treatment can be conducted after the image is formed, for example after removing the unhardened polymerizable layer.

In the system wherein the unexposed area is hardened, a thermal polymerization initiator or a photopolymerization initiator is preferably contained in the light-sensitive material. Where a thermal polymerization initiator is used, the initiator can function at the heat development to form an initiator radical uniformly. Where the photopolymerization initiator is used, the light-sensitive material is uniformly exposed to light after the developing step. The light source is determined based on the sensitive wavelength of the photopolymerization initiator. Examples of the light sources are described at the exposing step. The exposure amount is usually in the range of 10³ to 10⁷ ergs/cm².

After the heat development step, a hardened image can be formed on the light-sensitive layer. The hardened image is used in various technical fields. If necessary, some post treatment can be applied to the hardened image based on the chemical or physical differences between the hardened area and the unhardened area. The differences relate to solubility, surface adhesion, adhesion to the support, softening point, refraction, permittivity, diffusion character and coloring character. Examples of the post treatment include a removing step, a transferring step, a toning step and a dyeing step.

### [Removing step]

The unhardened area can be selectively removed to form a polymer image based on a difference in the solubility between the hardened area and the unhardened area.

After the heat development, the light-sensitive material is immersed in a solvent (an etching solution) to conduct the removing step. The solvent is an organic solvent, an aqueous alkaline solution or a mixture thereof. The solvent should have a function of dissolving or swelling the unhardened area. Examples of the alkaline compound include sodium hydroxide, potassium hydroxide, sodium carbonate, sodium silicate, potassium silicate, sodium metasilicate, potassium metasilicate, sodium phosphate, potassium silicate, ammonia and aminoalcohols (e.g., monoethanolamine, diethanolamine, triethanolamine). An organic solvent is preferably added to an aqueous etching solution. The organic liquid preferably is an alcohol or an ether. Examples of the alcohols include lower alcohols (e.g., methanol, ethanol, propanol, butanol), alcohols having an aromatic group (e.g., benzyl alcohol, phenethyl alcohol), polyhydric alcohols (e.g., ethylene glycol, diethylene glycol, triethylene glycol, polyethylene glycol) and aminoalcohols described above as the alkaline compounds. Examples of the ethers are cellosolves. The solvent may further contain the other additives such as a surface active agent and a defoaming agent. Commercially available developing solutions are also available. Before the removing step, a light-sensitive layer or other hydrophilic layers may be removed by washing the light-sensitive material with water, or peeling the hydrophilic layers.

The removing step can also be conducted by a sheet based on a difference in the adhesion to the sheet between the hardened area and the unhardened area. The hardened area or the unhardened area is selectively attached to the removing sheet. An image can be formed on the area remaining on the light-sensitive material. The removing sheet can be laminated on the light-sensitive material before the exposing step or the developing step.

### [Transferring step]

The obtained image can be transferred to an image receiving material based on a difference in the adhesion to the image receiving material between the hardened area and the unhardened area. The image receiving material can be laminated on the light-sensitive material before the exposing step or the developing step.

### [Toning step]

A colored substance (toner) can be attached to the hardened area or the unhardened area. The toner can be selectively attached to the unhardened area based on a difference in the adhesion to the toner between the hardened area and the unhardened area. After the hardened area or the unhardened area is removed, the toner can be attached to the remaining area. Further, the toner can be attached to an adhesive layer, after the hardened area or the unhardened area on the adhesive layer is selectively removed. Furthermore, the toner can be attached to an image receiving material, after the hardened area or the unhardened area is selectively transferred to the image receiving material.

### [Dyeing step]

The hardened area or the unhardened area can be selectively dyed to form a visible image. The dyeing step can also be conducted to an image receiving material, after the hardened area or the unhardened area is selectively transferred to the image receiving material.

The obtained image is available as a printing plate, a color proof, a hard copy or a relief image.

### EXAMPLE 1

### Preparation of aluminum support

A surface of an aluminum plate (according to JIS-A-1050) having thickness of 0.24 mm was ground using a nylon brush and an aqueous suspension of pumice stone of 400 mesh. The plate was well washed out with water. The aluminum plate was then immersed for etching in 10 % aqueous solution of sodium hydroxide at 70 °C for 60 seconds. The plate was washed out with running water, then neutralized with 20 % aqueous solution of nitric acid and washed out with water.

The obtained aluminum plate was subjected to an electrolytic surface-roughening treatment in 1 % aqueous solution of nitric acid containing 0.5 % aluminum nitrate in an anodically electric amount of 160 coulomb/dm² using sine wave alternating-corrugated current under such conditions as an anodic voltage of 12.7 V and a cathodically electric amount ratio to an anodically electric amount of 0.9. The center line average height (Ra) of the aluminum plate was 0.6 µm.

The aluminum plate was immersed in 1 % aqueous solution of sodium hydroxide at 40 °C for 30 seconds. The plate was then immersed in 30 % sulfuric acid at 55 °C for 1 minute. Further, the plate was subjected to anodizing treatment in 20 % aqueous solution of sulfuric acid at a current density of 2 A/dm² to form an anodic oxide layer having the thickness of 2.5 g/dm². The plate was washed with water and dried to obtain an aluminum support.

### Formation of polymerizable layer

The following coating solution was coated and dried on the aluminum support to form a polymerizable layer having the dry thickness of 1.3 µm.

| Coating solution of polymerizable layer | |
|---|---|
| Pentaerythritol tetraacrylate | 0.23 g |
| Allyl methacrylate-methacrylic acid copolymer (copolymerization ratio = 80/20) | 0.50 g |
| The following pigment dispersion | 4.47 g |
| 0.56 Wt.% methanol solution of the following additive | 0.56 g |
| 0.3 Wt.% aqueous solution of a surface active agent (Megafac F176PF, Dainippon Ink & Chemicals Inc.) | 1.00 g |
| Methyl ethyl ketone | 0.62 g |
| Propylene glycol monomethyl ether | 2.50 g |

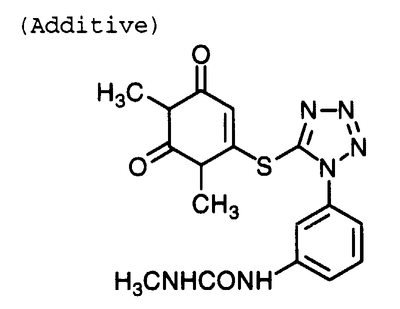

| Pigment dispersion | |
|---|---|
| Pigment (Chromofutal Red A2B, Ciba-Geigy) | 6.90 g |
| Allyl methacrylate-methacrylic acid copolymer (copolymerization ratio = 80/20) | 5.73 g |
| Cyclohexanone | 12.90 g |
| Propylene glycol monomethyl ether | 74.47 g |

### Preparation of silver halide emulsion

Gelatin, potassium bromide and water were placed in a vessel and kept at 55 °C. The following thioether compound (2.0 × 10⁻³ mol based on the amount of silver nitrate) was added to the vessel. Further, an aqueous solution of silver nitrate and an aqueous solution of potassium bromide containing a rhodium ammonium chloride (the molar ratio of rhodium to the total amount of potassium iodide and silver nitrate is 4×10⁻⁸ mol) were added to the vessel according to a pAg controlled double jet method while keeping the pAg of 9.2 in the reaction vessel to prepare a silver iodobromide emulsion. Further, a potassium bromide solution containing hexachloroiridate(III) salt (the molar ratio of iridium to silver is 10⁻⁷ mol) was twice added to the emulsion at the same temperature and pAg 8.9 according to a double jet method to obtain a core/shell type silver iodobromide emulsion having the following composition. 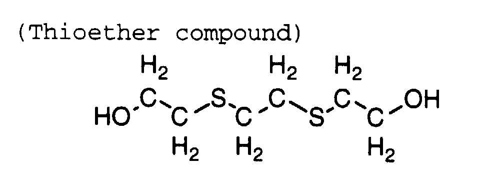
Core: Silver iodobromide (silver iodide content: 7.5 mol %)
Shell: Pure silver bromide
Core/shell: 3/7 (molar ratio of silver)
Average silver iodide content: 2.3 mol %
Average grain size: 0.28 µm

The grains of the obtained emulsion were monodispersed. In the emulsion, 98 % of the grains have a grain size within the range of the average grain size ± 40 %.

After the emulsion was desalted, a methanol solution of the following sensitizing dye (10⁻² M per liter) was added to the emulsion. The amount of the methanol solution was so adjusted that 200 ml of the solution was used based on 1 mol of silver nitrate. The emulsion was then adjusted to pH 6.2 and pAg 8.7. The emulsion was then subjected to a gold sulfur sensitization using sodium thiosulfate and chloroauric acid.

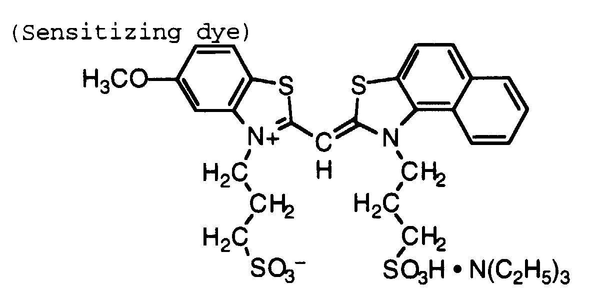

### Preparation of mercaptosilver compound

In 60 g of water, 2.8 g of polyvinyl alcohol (PVA-420, Kuraray Co., Ltd.) was dissolved. To the solution, 10.3 g of 0.1 N potassium hydroxide solution was added. The mixture was heated to 50 °C. To the solution, an aqueous solution containing 0.93 mmol of silver nitrate and a methanol solution containing 0.93 mmol of the following mercapto compound were simultaneously dropwise added for 20 minutes. After the addition, the mixture was stirred for 20 minutes. The mixture was cooled to the room temperature, and was adjusted to pH 6.3. Thus, a mercaptosilver compound (formed by converting -SH of the following compound to -SAg) was prepared. The yield was 113.68 g. The solution of the obtained compound had pAg of 6.31.

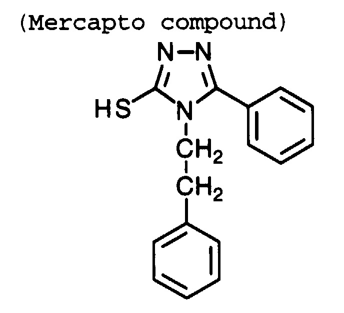

### Formation of light-sensitive layer

The following coating solution was coated and dried on the polymerizable layer to form a light-sensitive layer having the dry thickness of about 1.2 µm.

| Coating solution of light-sensitive layer | |
|---|---|
| Polyvinyl alcohol (PVA-405, Kuraray Co., Ltd.) | 5.23 g |
| 5 Wt.% aqueous solution of the following surface active agent | 1.68 g |
| 10 Wt.% aqueous dispersion of the following reducing agent | 10.08 g |
| Phosphate buffer (KH₂PO₄: 0.025 mol per liter and Na₂HPO₄: 0.025 mol per liter) | 1.68 g |
| 0.5 Wt.% aqueous solution of potassium bromide | 2.10 g |
| 0.11 Wt.% aqueous solution of the above-prepared mercaptosilver compound | 3.20 g |
| The above-prepared silver halide emulsion (diluted 4.3 times with water) | 18.48 g |
| Water | 47.69 g |

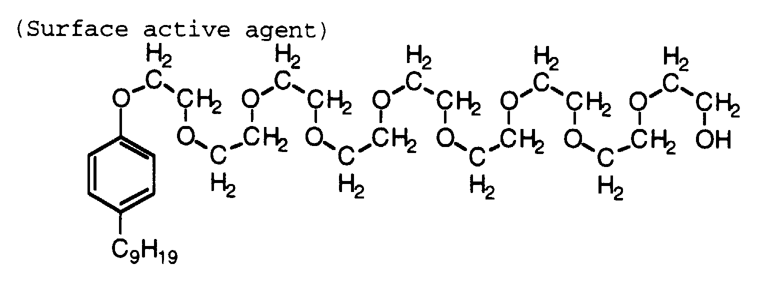

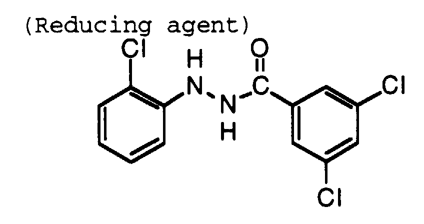

### Preparation of base precursor dispersion

In 750 g of 3 wt.% aqueous solution of polyvinyl alcohol (PVA-205, Kuraray Co., Ltd.) was dispersed 250 g of powder of the following base precursor using Dynomill dispersing device.

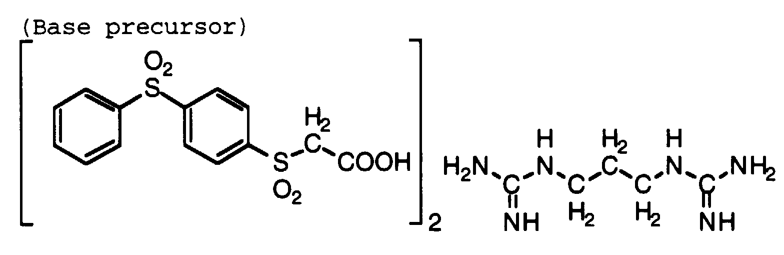

### Formation of overcoating layer

The following coating solution was coated and dried on the light-sensitive layer to form an overcoating layer having the dry thickness of about 3.7 µm.

| Coating solution of overcoating layer | |
|---|---|
| Polyvinyl alcohol set forth in Table 3 | 15.0 g |
| The base precursor dispersion | 5.63 g |
| 5 Wt.% aqueous solution of the surface active agent shown above | 3.00 g |
| Water | 135.0 g |

### (Image formation)

The light-sensitive material was exposed to light for 3 seconds by a tungsten lamp of 500 W and through a band pass filter of 500 nm. The aluminum support of the light-sensitive material was placed on a hot plate heated at 145 °C. The light-sensitive material was washed with water to remove the light-sensitive layer and the overcoating layer. The polymerizable layer was etched with an aqueous alkaline solution, which was obtained by diluting Fuji DP-4 (Fuji Photo Film Co., Ltd.) eight times. The light-sensitive material was well washed with water to form a polymer relief image on the exposed area of the polymerizable layer.

### (Evaluation of image and solubility of overcoating layer)

The above-formed image and the solubility of the overcoating layer in water were evaluated. The results were set forth in Table 3.

In Table 3, the values of the column "image formation" mean relative sensitivities of the light-sensitive materials, wherein the sensitivity of the light-sensitive material No. 1-a is assumed as 100. The values of the column "solubility in water" mean the temperature required for dissolving 40 mg of the overcoating layer in 100 g of water after the layer is heated.

**TABLE 3**

| | Polyvinyl alcohol | | | | Image formation | Solubility in water |
|---|---|---|---|---|---|---|
| Material No. | No. | Saponification degree | Acidic moiety | Polymerization degree | | |
| 1-a | 11 | 97.0 % | COOH | 600 | 100 | < 25 °C |
| 1-b | 12 | 94.0 % | COOH | 1,000 | 90 | < 25 °C |
| 1-c | x | 98.5 % | None | 600 | 100 | 80 °C |
| 1-d | y | 93.5 % | None | 1,000 | 90 | 60 °C |
| 1-e | z | 88.0 % | None | 1,000 | 1 | < 25 °C |

It is apparent from the results shown in Table 3 that a clear image can be formed and the solubility of the heated overcoating layer can be increased by using an acid modified polyvinyl alcohol as a binder of the overcoating layer.

### EXAMPLES 2

The light-sensitive material (1-a) was imagewise exposed to light by scanning the material with an air dried argon ion laser of 488 nm (exposure on the film surface: 3 µJ/cm²). The aluminum support of the light-sensitive material was placed on a hot plate heated at 145 °C while opening the surface of the material in the air. As a result, silver halide was reduced and the polymerizable layer was hardened. A silver image was observed within the exposed area. The light-sensitive material was washed with water to remove the light-sensitive layer and the overcoating layer. The polymerizable layer was etched with a brush and the aqueous alkaline solution used in Example 1 in an automatic brushing developer to remove the polymerizable layer within the unexposed area. The light-sensitive material was well washed with water to form a hardened image. The obtained relief image was used as a printing plate in a printing machine. As a result, a clear print was obtained.

### EXAMPLE 3

An undercoating layer and a polymerizable layer were coated on an aluminum support in the same manner as in Example 1.

### Formation of light-sensitive layer

The following coating solution was coated and dried on the polymerizable layer to form a light-sensitive layer having the dry thickness of about 4.0 µm.

| Coating solution of light-sensitive layer | |
|---|---|
| Acid modified polyvinyl alcohol (3) | 5.23 g |
| 5 Wt.% aqueous solution of the surface active agent used in Example 1 | 1.68 g |
| 10 Wt.% aqueous dispersion of the reducing agent used in Example 1 | 10.08 g |
| 0.11 Wt.% aqueous solution of the mercaptosilver compound used in Example 1 | 3.20 g |
| The silver halide emulsion (diluted 4.3 times with water) used in Example 1 | 18.48 g |
| The base precursor dispersion used in Example 1 | 6.00 g |

### (Image formation)

The light-sensitive material was imagewise exposed to light by scanning the material with an air dried argon ion laser of 488 nm (exposure on the film surface: 3 µJ/cm²). The aluminum support of the light-sensitive material was placed on a hot plate heated at 145 °C while opening the surface of the material in the air. As a result, silver halide was reduced and the polymerizable layer was hardened. A silver image was observed within the exposed area. The light-sensitive material was washed with water to remove the light-sensitive layer. The light-sensitive layer was well dissolved in water. The polymerizable layer was etched with a brush and the aqueous alkaline solution used in Example 1 in an automatic brushing developer to remove the polymerizable layer within the unexposed area. The light-sensitive material was well washed with water to form a hardened image. The obtained relief image was used as a printing plate in a printing machine. As a result, a clear print was obtained.

### EXAMPLE 4

### Purification of acid modified polyvinyl alcohol (3)

The acid modified polyvinyl alcohol (3) used in Example 3 contained sodium acetate as impurity (amount: 5 %), which was formed at the saponification reaction of chaining vinyl acetate components to vinyl alcohol components.

To 200 g of methanol containing 1 % water, 100 g of the acid modified polyvinyl alcohol (3) was added. The mixture was stirred at 50 °C for 2 hours to obtain a solution. The solution was filtered to fractionate polyvinyl alcohol. These procedures were repeated six times to obtain a purified acid modified polyvinyl alcohol (3). The sodium acetate content of the polyvinyl alcohol was 0.3 %.

### Preparation of light-sensitive material

A light-sensitive material was prepared in the same manner as in Example 3, except that the above-purified acid modified polyvinyl alcohol (3) was used as the binder of the light-sensitive layer.

### (Image formation)

An image was formed using the above-prepared light-sensitive material in the same manner as in Example 3.

The obtained relief image was used as a printing plate in a printing machine. The results were better than those of Example 3.

The printable number of the sheets in Example 4 (the number counted until a plate wearing was not caused) was 40 % larger than the number in Example 3. In more detail, fine spots were scarcely omitted from the highlight area of the print even after a large number of sheets were printed. It is apparent from these results that the hardening reaction is accelerated by reducing the amount of sodium acetate contained in the light-sensitive material. The obtained hard image further improves the plate wear.

## Claims

1. A silver halide light-sensitive material which comprises a support, a light-sensitive polymerizable layer and an overcoating layer in that order, said light-sensitive polymerizable layer containing silver halide, a reducing agent and an ethylenically unsaturated polymerizable compound or a cross-linkable polymer, wherein the overcoating layer contains polyvinyl alcohol having an acidic group or a salt thereof in its molecule,
the acidic group being carboxyl, sulfo or phosphono.

2. The silver halide light-sensitive material as claimed in claim 1, wherein the salt consists of the acidic group with a metal cation,
the acidic group being carboxyl, sulfo or phosphono.

3. The silver halide light-sensitive material as claimed in claim 1, wherein the polyvinyl alcohol has a molecular weight in the range of 3,000 to 500,000.

4. The silver halide light-sensitive material as claimed in claim 1, wherein the polyvinyl alcohol is a copolymer having the following units (A), (B) and (C1): 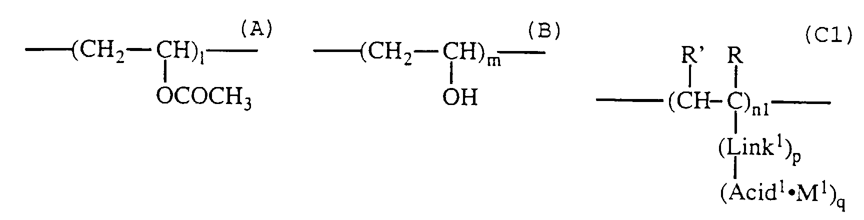 in which (A) means a vinyl acetate unit; (B) means a vinyl alcohol unit; (C1) means a modified unit; the ratio of 1 to l+m+n1 is 0 to 0.3; the ratio of m to l+m+n1 is 0.5 to 0.999; the ratio of nl to l+m+n1 is 0.001 to 0.2; R is hydrogen, an alkyl group, carboxyl or a salt thereof; R' is hydrogen, carboxyl or a salt thereof; p is 0 or 1; Linkl is a linking group having valences of q+1; q is a natural number; Acid¹ is carboxyl, sulfo or phosphono; and M¹ is a cation.

5. The silver halide light-sensitive material as claimed in claim 1, wherein the polyvinyl alcohol is a copolymer having the following units (A), (B) and (C2): 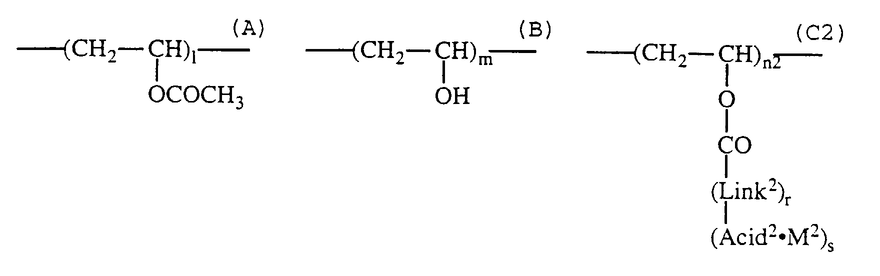 in which (A) means a vinyl acetate unit; (B) means a vinyl alcohol unit; (C2) means a modified unit; the ratio of 1 to l+m+n2 is 0 to 0.3; the ratio of m to l+m+n2 is 0.5 to 0.999; the ratio of n2 to l+m+n2 is 0.001 to 0.2; r is 0 or 1; Link² is a linking group having valences of s+1; s is a natural number; Acid² is carboxyl, sulfo or phosphono; and M² is a cation.

6. The silver halide light-sensitive material as claimed in claim 1, wherein the overcoating layer contains the polyvinyl alcohol in an amount of 0.05 to 20 g/m².

7. The silver halide light-sensitive material as claimed in claim 1, wherein the overcoating layer comprises the polyvinyl alcohol and a base precursor.

8. The silver halide light-sensitive material as claimed in claim 1, wherein the light-sensitive polymerizable layer comprises a polymerizable layer containing the polymerizable compound or the cross-linkable polymer and a light-sensitive layer containing the silver halide, and the light-sensitive material comprises the support, the polymerizable layer, the light-sensitive layer and the overcoating layer in that order.

9. A silver halide light-sensitive material which comprises a support, a polymerizable layer and a light-sensitive layer in that order, said polymerizable layer containing an ethylenically unsaturated polymerizable compound or a cross-linkable polymer, said light-sensitive layer containing silver halide, and a reducing agent being contained in the polymerizable layer or the light-sensitive layer, wherein the light-sensitive layer further contains polyvinyl alcohol having an acidic group or a salt thereof in its molecule,
the acidic group being carboxyl, sulfo or phosphono.

10. The silver halide light-sensitive material as claimed in claim 9, wherein the salt consists of the acidic group with a metal cation,
the acidic group being carboxyl, sulfo or phosphono.

11. The silver halide light-sensitive material as claimed in claim 9, wherein the polyvinyl alcohol has a molecular weight in the range of 3,000 to 500,000.

12. The silver halide light-sensitive material as claimed in claim 9, wherein the polyvinyl alcohol is a copolymer having the following repeating units: 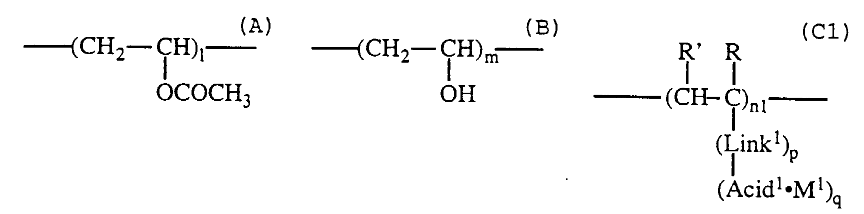 in which (A) means a vinyl acetate unit; (B) means a vinyl alcohol unit; (C1) means a modified unit; the ratio of 1 to l+m+n1 is 0 to 0.3; the ratio of m to l+m+n1 is 0.5 to 0.999; the ratio of nl to l+m+n1 is 0.001 to 0.2; R is hydrogen, an alkyl group, carboxyl or a salt thereof; R' is hydrogen, carboxyl or a salt thereof; p is 0 or 1; Linkl is a linking group having valences of q+1; q is a natural number; Acid¹ is carboxyl, sulfo or phosphono; and M¹ is a cation.

13. The silver halide light-sensitive material as claimed in claim 9, wherein the polyvinyl alcohol is a copolymer having the following repeating units: 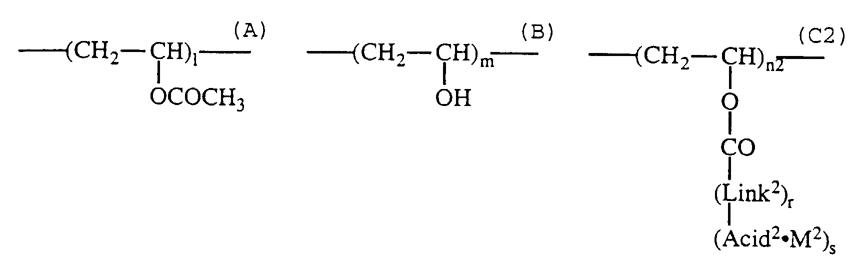 in which (A) means a vinyl acetate unit; (B) means a vinyl alcohol unit; (C2) means a modified unit; the ratio of l to l+m+n2 is 0 to 0.3; the ratio of m to l+m+n2 is 0.5 to 0.999; the ratio of n2 to l+m+n2 is 0.001 to 0.2; r is 0 or 1; Link² is a linking group having valences of s+1; s is a natural number; Acid² is carboxyl, sulfo or phosphono; and M² is a cation.

14. The silver halide light-sensitive material as claimed in claim 9, wherein the light-sensitive layer contains the polyvinyl alcohol in an amount of 0.05 to 20 g/m².

15. The silver halide light-sensitive material as claimed in claim 9, wherein the light-sensitive layer further contains a base precursor.

## Patentansprüche

1. Lichtempfindliches Silberhalogenidmaterial, umfassend, in der folgenden Reihenfolge, einen Träger, eine lichtempfindliche polymerisierbare Schicht und eine Deckschicht, wobei die lichtempfindliche polymerisierbare Schicht Silberhalogenid, ein Reduktionsmittel und eine ethylenisch ungesättigte polymerisierbare Verbindung oder ein vemetzbares Polymer enthält und wobei die Deckschicht einen Polyvinylalkohol mit einer Säuregruppe oder einem Salz davon in dessen Molekül enthält, wobei die Säuregruppe eine Carboxylgruppe, eine Sulfogruppe oder eine Phosphonogruppe ist.

2. Lichtempfindliches Silberhalogenidmaterial nach Anspruch 1, wobei das Salz aus der Säuregruppe und einem Metallkation gebildet wird und wobei die Säuregruppe eine Carboxylgruppe, eine Sulfogruppe oder eine Phosphonogruppe ist.

3. Lichtempfindliches Silberhalogenidmaterial nach Anspruch 1, wobei der Polyvinylalkohol ein Molekulargewicht im Bereich von 3000 bis 500000 besitzt.

4. Lichtempfindliches Silberhalogenidmaterial nach Anspruch 1, wobei der Polyvinylalkohol ein Copolymer mit den folgenden Einheiten (A), (B) und (C1) ist: 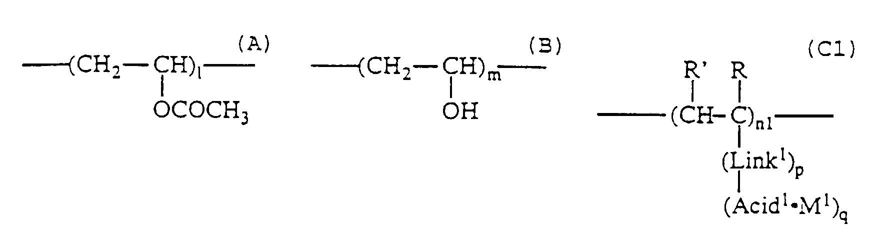 worin (A) eine Vinylacetat-Einheit ist; (B) ist eine Vinylalkohol-Einheit; (C1) ist eine modifizierte Einheit; das Verhältnis von 1 zu l+m+n1 liegt im Bereich von 0 bis 0,3; das Verhältnis von m zu l+m+n1 liegt im Bereich von 0,5 bis 0,999; das Verhältnis von n1 zu l+m+n1 liegt im Bereich von 0,001 bis 0,2; R ist Wasserstoff, eine Alkylgruppe, eine Carboxylgruppe oder ein Salz davon; R' ist Wasserstoff, eine Carboxylgruppe oder ein Salz davon; p ist 0 oder 1; Link¹ ist eine Verbindungsgruppe mit der Wertigkeit q+1; q ist eine natürliche Zahl; Acid¹ ist eine Carboxylgruppe, eine Sulfogruppe oder eine Phosphonogruppe; und M¹ ist ein Kation.

5. Lichtempfindliches Silberhalogenidmaterial nach Anspruch 1, wobei der Polyvinylalkohol ein Copolymer mit den folgenden Einheiten (A), (B) und (C2) ist: 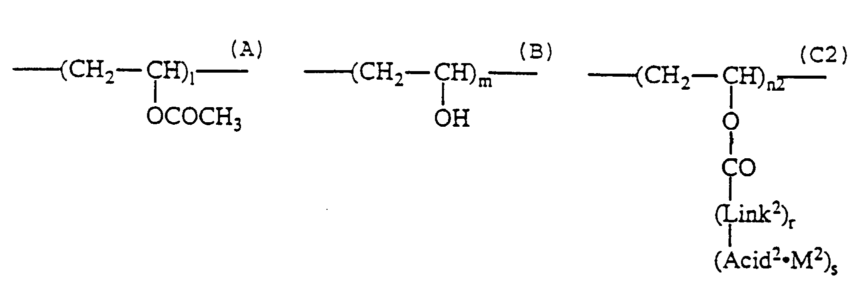 worin (A) eine Vinylacetat-Einheit ist; (B) ist eine Vinylalkohol-Einheit; (C2) ist eine modifizierte Einheit; das Verhältnis von 1 zu l+m+n2 liegt im Bereich von 0 bis 0,3; das Verhältnis von m zu l+m+n2 liegt im Bereich von 0,5 bis 0,999; das Verhältnis von n2 zu l+m+n2 liegt im Bereich von 0,001 bis 0,2; r ist 0 oder 1; Link² ist eine Verbindungsgruppe mit der Wertigkeit s+1; s ist eine natürliche Zahl; Acid² ist eine Carboxylgruppe, eine Sulfogruppe oder eine Phosphonogruppe; und M² ist ein Kation.

6. Lichtempfindliches Silberhalogenidmaterial nach Anspruch 1, wobei die Deckschicht den Polyvinylalkohol in einer Menge im Bereich von 0,05 bis 20 g/m² enthält.

7. Lichtempfindliches Silberhalogenidmaterial nach Anspruch 1, wobei die Deckschicht den Polyvinylalkohol und einen Basenvorläufer enthält.

8. Lichtempfindliches Silberhalogenidmaterial nach Anspruch 1, wobei die lichtempfindliche polymerisierbare Schicht eine polymerisierbare Schicht mit der polymerisierbaren Verbindung oder dem vemetzbaren Polymer und eine lichtempfindliche Schicht mit dem Silberhalogenid umfaßt und wobei das lichtempfindliche Material, in der folgenden Reihenfolge, den Träger, die polymerisierbare Schicht, die lichtempfindliche Schicht und die Deckschicht umfaßt.

9. Lichtempfindliches Silberhalogenidmaterial, umfassend, in der folgenden Reihenfolge, einen Träger, eine polymerisierbare Schicht und eine lichtempfindliche Schicht, wobei die polymerisierbare Schicht eine ethylenisch ungesättigte polymerisierbare Verbindung oder ein vemetzbares Polymer enthält, wobei die lichtempfindliche Schicht Silberhalogenid enthält, wobei ein Reduktionsmittel in der polymerisierbaren Schicht oder in der lichtempfindlichen Schicht enthalten ist, wobei die lichtempfindliche Schicht weiterhin einen Polyvinylalkohol mit einer Säuregruppe oder einem Salz davon in dessen Molekül enthält und wobei die Säuregruppe eine Carboxylgruppe, eine Sulfogruppe oder eine Phosphonogruppe ist.

10. Lichtempfindliches Silberhalogenidmaterial nach Anspruch 9, wobei das Salz aus der Säuregruppe und einem Metallkation gebildet wird und wobei die Säuregruppe eine Carboxylgruppe, eine Sulfogruppe oder eine Phosphonogruppe ist.

11. Lichtempfindliches Silberhalogenidmaterial nach Anspruch 9, wobei der Polyvinylalkohol ein Molekulargewicht im Bereich von 3000 bis 500000 besitzt.

12. Lichtempfindliches Silberhalogenidmaterial nach Anspruch 9, wobei der Polyvinylalkohol ein Copolymer mit den folgenden sich wiederholenden Einheiten ist: 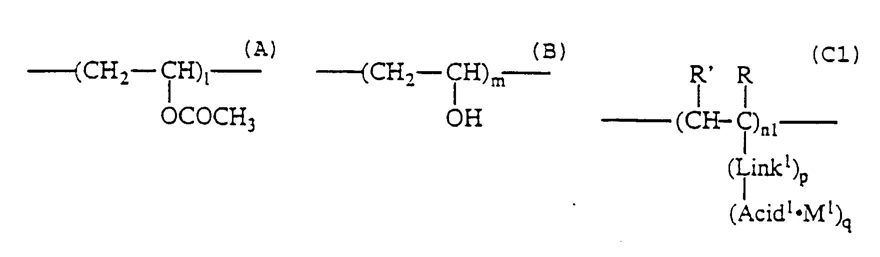 worin (A) eine Vinylacetat-Einheit ist; (B) ist eine Vinylalkohol-Einheit; (C1) ist eine modifizierte Einheit; das Verhältnis von 1 zu l+m+n1 liegt im Bereich von 0 bis 0,3; das Verhältnis von m zu l+m+n1 liegt im Bereich von 0,5 bis 0,999; das Verhältnis von n1 zu l+m+n1 liegt im Bereich von 0,001 bis 0,2; R ist Wasserstoff, eine Alkylgruppe, eine Carboxylgruppe oder ein Salz davon; R' ist Wasserstoff, eine Carboxylgruppe oder ein Salz davon; p ist 0 oder 1; Link¹ ist eine Verbindungsgruppe mit der Wertigkeit q+1; q ist eine natürliche Zahl; Acid¹ ist eine Carboxylgruppe, eine Sulfogruppe oder eine Phosphonogruppe; und M¹ ist ein Kation.

13. Lichtempfindliches Silberhalogenidmaterial nach Anspruch 9, wobei der Polyvinylalkohol ein Copolymer mit den folgenden sich wiederholenden Einheiten ist: 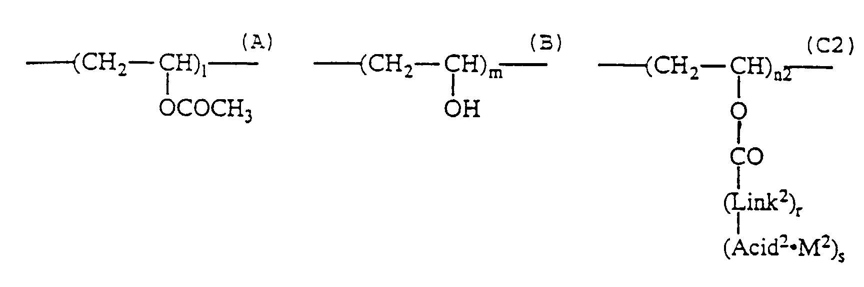 worin (A) eine Vinylacetat-Einheit ist; (B) ist eine Vinylalkohol-Einheit; (C2) ist eine modifizierte Einheit; das Verhältnis von 1 zu l+m+n2 liegt im Bereich von 0 bis 0,3; das Verhältnis von m zu l+m+n2 liegt im Bereich von 0,5 bis 0,999; das Verhältnis von n2 zu l+m+n2 liegt im Bereich von 0,001 bis 0,2; r ist 0 oder 1; Link² ist eine Verbindungsgruppe mit der Wertigkeit s+1; s ist eine natürliche Zahl; Acid² ist eine Carboxylgruppe, eine Sulfogruppe oder eine Phosphonogruppe; und M² ist ein Kation.

14. Lichtempfindliches Silberhalogenidmaterial nach Anspruch 9, wobei die lichtempfindliche Schicht den Polyvinylalkohol in einer Menge im Bereich von 0,05 bis 20 g/m² enthält.

15. Lichtempfindliches Silberhalogenidmaterial nach Anspruch 9, wobei die lichtempfindliche Schicht weiterhin einen Basenvorläufer enthält.

## Revendications

1. Matériau photosensible à l'halogénure d'argent qui comprend un support, une couche polymérisable photosensible et une couche de couverture dans cet ordre, ladite couche polymérisable photosensible contenant de l'halogénure d'argent, un agent réducteur et un composé polymérisable éthyléniquement insaturé ou un polymère réticulable, dans lequel la couche de couverture contient du poly(alcool vinylique) présentant un groupe acide ou un sel de celui-ci dans sa molécule, le groupe acide étant un groupe carboxyle, sulfo ou phosphono.

2. Matériau photosensible à l'halogénure d'argent selon la revendication 1, dans lequel le sel consiste en le groupe acide avec un cation métallique, le groupe acide étant un groupe carboxyle, sulfo ou phosphono.

3. Matériau photosensible à l'halogénure d'argent selon la revendication 1, dans lequel le poly(alcool vinylique) présente un poids moléculaire dans l'intervalle de 3 000 à 500 000.

4. Matériau photosensible à l'halogénure d'argent selon la revendication 1, dans lequel le poly(alcool vinylique) est un copolymère présentant les unités (A), (B) et (C1) suivantes : 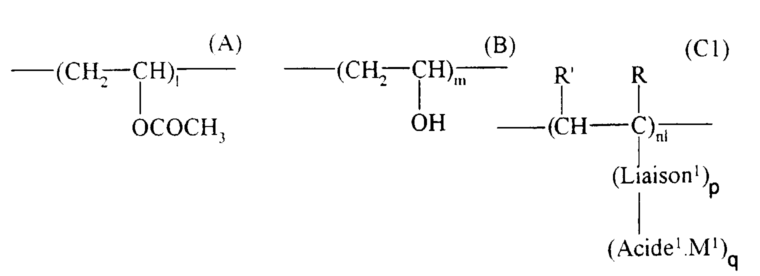 dans lesquelles (A) indique une unité d'acétate de vinyle; (B) indique une unité d'alcool vinylique; (C1) indique une unité modifiée; le rapport de I à 1 + m + n1 est de 0 à 0,3; le rapport de m à l + m +n1 est de 0,5 à 0,999; le rapport de n1 à l + m + n1 est de 0,001 à 0,2. R est l'hydrogène, un groupe alkyle, carboxyle ou un sel de celui-ci; R' est l'hydrogène, un groupe carboxyle ou un sel de celui-ci; p est égal à 0 ou à 1; Liaison¹ est un groupe de liaison présentant les valences de q + 1; q est un entier naturel; Acide' est un groupe carboxyle, sulfo ou phosphono; et M¹ est un cation.

5. Matériau photosensible à l'halogénure d'argent selon la revendication 1, dans lequel le poly(alcool vinylique) est un copolymère présentant les unités (A), (B) et (C2) suivantes : 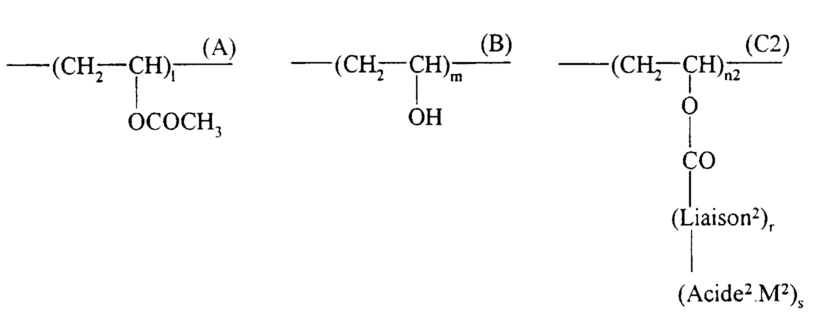 dans lesquelles (A) indique une unité d'acétate de vinyle; (B) indique une unité d'alcool vinylique; (C2) indique une unité modifiée; le rapport de 1 à 1 + m + n2 est de 0 à 0,3; le rapport de m à 1 + m + n2 est de 0,5 à 0,999; le rapport de n2 à 1 + m + n2 est de 0,001 à 0,2; r est égal à 0 ou à 1; Liaison² est un groupe de liaison présentant les valences de s + 1; s est un entier naturel; Acide² est un groupe carboxyle, sulfo ou phosphono; et M² est un cation.

6. Matériau photosensible à l'halogénure d'argent selon la revendication 1, dans lequel la couche de couverture contient le poly(alcool vinylique) dans une quantité de 0,05 à 20 g/m².

7. Matériau photosensible à l'halogénure d'argent selon la revendication 1, dans lequel la couche de couverture comprend le poly(alcool vinylique) et un précurseur de base.

8. Matériau photosensible à l'halogénure d'argent selon la revendication 1, dans lequel la couche polymérisable photosensible comprend une couche polymérisable contenant le composé polymérisable ou le polymère réticulable et une couche photosensible contenant l'halogénure d'argent, et le matériau photosensible comprend le support, la couche polymérisable, la couche photosensible et la couche de couverture dans cet ordre.

9. Matériau photosensible à l'halogénure d'argent qui comprend un support, une couche polymérisable et une couche photosensible dans cet ordre, ladite couche polymérisable contenant un composé polymérisable éthyléniquement insaturé ou un polymère réticulable, ladite couche photosensible contenant de l'halogénure d'argent et un agent réducteur étant contenu dans la couche polymérisable ou la couche photosensible, dans lequel la couche photosensible contient en outre du poly(alcool vinylique) présentant un groupe acide ou un sel de celui-ci dans sa molécule, le groupe acide étant un groupe carboxyle, sulfo ou phosphono.

10. Matériau photosensible à l'halogénure d'argent selon la revendication 9, dans lequel le sel consiste en le groupe acide avec un cation métallique, le groupe acide étant un groupe carboxyle, sulfo ou phosphono.

11. Matériau photosensible à l'halogénure d'argent selon la revendication 9, dans lequel le poly(alcool vinylique) présente un poids moléculaire dans l'intervalle de 3 000 à 500 000.

12. Matériau photosensible à l'halogénure d'argent selon la revendication 9, dans lequel le poly(alcool vinylique) est un copolymère présentant les unités répétitives suivantes : 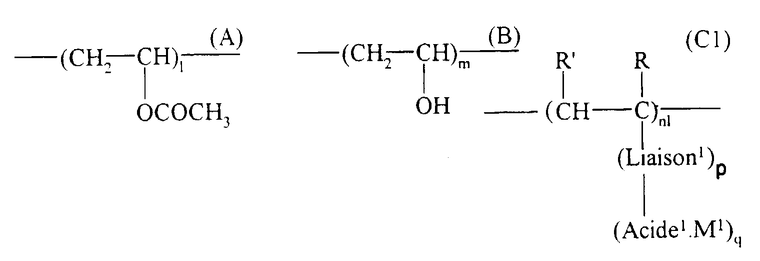 dans lesquelles (A) indique une unité d'acétate de vinyle; (B) indique une unité d'alcool vinylique; (C1) indique une unité modifiée; le rapport de 1 à 1 + m + n1 est de 0 à 0,3; le rapport de m à 1 + m +n1 est de 0,5 à 0,999; le rapport de n1 à 1 + m + n1 est de 0,001 à 0,2; R est l'hydrogène, un groupe alkyle, carboxyle ou un sel de celui-ci, R' est l'hydrogène; un groupe carboxyle ou un sel de celui-ci; p est égal à 0 ou à 1; Liaison' est un groupe de liaison présentant les valences de q +1; q est un entier naturel; Acide' est un groupe carboxyle, sulfo ou phosphono; et M' est un cation.

13. Matériau photosensible à l'halogénure d'argent selon la revendication 9, dans lequel le poly(alcool vinylique) est un copolymère présentant les unités répétitives suivantes : 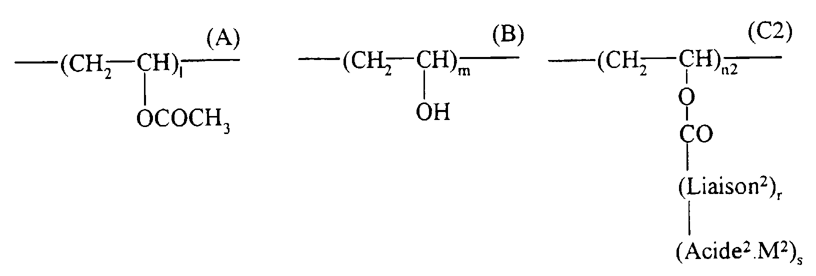 dans lesquelles (A) indique une unité d'acétate de vinyle; (B) indique une unité d'alcool vinylique; (C2) indique une unité modifiée; le rapport de 1 à 1 + m + n2 est de 0 à 0,3; le rapport de m à 1 + m + n2 est de 0,5 à 0,999; le rapport de n2 à 1 + m + n2 est de 0,001 à 0,2; r est égal à 0 ou à 1; Liaison² est un groupe de liaison présentant les valences de s + 1; s est un entier naturel; Acide² est un groupe carboxyle, sulfo ou phosphono; et M² est un cation.

14. Matériau photosensible à l'halogénure d'argent selon la revendication 9, dans lequel la couche photosensible contient le poly(alcool vinylique) dans une quantité de 0,05 à 20 g/m².

15. Matériau photosensible à l'halogénure d'argent selon la revendication 9, dans lequel la couche photosensible contient en outre un précurseur de base.
